# EUROPEAN PATENT APPLICATION

(11) **EP 4 603 878 A1**
(43) Date of publication of application: **20.08.2025**
(21) Application number: 23877628.0
(22) Date of filing: 10.10.2023
(51) Int. Cl.: G01T 1/24, G01T 7/00, H01L 31/08, G01T 1/16, G01T 1/161, H01L 27/146

(54) **RADIATION DETECTOR BENDABLE IN TWO DIRECTIONS**

(30) Priority: 13.10.2022 KR 20220131379; 13.10.2022 KR 20220131429; 10.03.2023 KR 20230031538
(71) Applicant: DRTECH CORPORATION, Seongnam-si, Gyeonggi-do 13216 (KR)
(72) Inventor: MOON, Beom Jin, Suwon-si Gyeonggi-do 16707 (KR); KIM, Hyeong Sik, Hwaseong-si Gyeonggi-do 18489 (KR); GIL, Yong Cheol, Suwon-si Gyeonggi-do 16571 (KR); PARK, Jong Yoon, Seongnam-si Gyeonggi-do 13357 (KR)
(74) Representative: Jung, Minkyu
(86) International application number: PCT/KR2023/015528
(87) International publication number: WO 2024/080701

(57) **Abstract**

This radiation detector comprises: a detector panel; a front and a rear protection panel disposed on either side of the detector panel; and a support member supporting the detector panel and the front and rear protection panels. The detector panel and the front and rear protection panels are configured so as to be able to bend together in two directions.

## Description

### [Technical Field]

The present invention relates to a radiation detector.

### [Background Art]

Radiation imaging devices that use radiation such as X-rays or gamma rays to obtain internal images of objects are being used in various fields such as the medical and industrial fields. A radiation imaging device includes a radiation source that generates radiation and a radiation detector that detects radiation that has passed through an object.

A radiation detector for obtaining images of an object such as a pipe is usually called an industrial radiation detector. Since industrial radiation detectors should be disposed close to objects of various shapes and perform imaging, it is desirable to manufacture an industrial radiation detector in a bendable form. A radiation detector for performing radiography for the purpose of non-destructive inspection of a pipe needs to be formed so that both images of inner and outer surfaces of a pipe are captured and images of the desired quality are obtained and read according to the purpose and photographing environment.

### [Related Art Document]

### [Patent Document]

(Patent Document 1) United States Laid-open Patent Publication No. 2021-0190704 (Published on June 24, 2021)

### [Disclosure]

### [Technical Problem]

The present invention is directed to providing a radiation detector capable of performing non-destructive inspection of pipes of various sizes, obtaining high-quality images according to photographing conditions and environment, and reading the images more accurately.

The present invention is also directed to providing a radiation detector that may be easily inserted into a pipe and deformed according to a shape of an inner surface of the pipe to perform stable radiography.

The present invention is also directed to providing a radiation detector that allows a miniaturized design by optimizing a connector structure of a thin film transistor and may perform imaging by being effectively brought into close contact with an object such as a pipe.

The present invention is also directed to providing a front protection unit that protects a surface of a portable bendable radiation detector. The present invention is also directed to providing a bendable radiation detector that is portable and movable while maintaining a certain distance from a subject having a round surface.

However, objects according to the technical spirit of the present invention are not limited to the above-described object and other objects may be present.

### [Technical Solution]

One aspect of the present invention provides a radiation detector which includes a detector panel, a front protection panel and a rear protection panel that are disposed at both sides of the detector panel, and a support member supporting the detector panel and the front and rear protection panels. The detector panel and the front and rear protection panels are bendable together in two directions.

The detector panel and the front and rear protection panels may be bendable together in a state in which a difference in displacement with respect to each other is allowed.

Each of the front and rear protection panels may include a fastening slot, and the support member may include a fastening rod that is inserted into the fastening slot and support the front and rear protection panels. The fastening slot may have a long hole shape to allow relative movement along the fastening slot when the front and rear protection panels are bent together.

Each of the front and rear protection panels may include a movement-limiting fastening slot, and the support member may include a movement-limiting fastening rod inserted into the movement-limiting fastening slot. The movement-limiting fastening slot may be configured to block movement of the movement-limiting fastening rod within the movement-limiting fastening slot when the front and rear protection panels are bent.

The radiation detector may further include a front cover disposed in front of the front protection panel, and the fastening rod may pass through the fastening slots of the front and rear protection panels and be fastened to the front cover.

The support member may include a first support and a second support that are disposed to be spaced apart from each other, a bending part that couples the first and second supports and is formed to be bendable, a fixed support block that is fixedly provided on the first support, and a movable support block that is movably provided on the second support. An end portion of one side of the detector panel may be fixed to the fixed support block and an end portion of the other side may be fixed to the movable support block. Accordingly, when the detector panel is bent, the end portion of the other side of the detector panel may be moved together with the movable support block.

A radiation detector for detecting X-rays and generating a corresponding output signal according to one embodiment of the present invention includes a thin film transistor (TFT) array including a plurality of pixel TFT circuits, each of which generates the output signal according to intensity of detected X-rays, a gate circuit configured to apply a gate signal for driving the plurality of pixel TFT circuits to the TFT array, and a readout circuit configured to receive the output signals generated by the plurality of pixel TFT circuits and transmit the received output signals to an external device. The gate circuit includes a gate chip-on-film configured to generate the gate signal and apply the generated gate signal to the TFT array, and a gate connection flexible printed circuit board (FPCB) that is circuit-coupled to the gate chip-on-film to receive a driving signal for generating the gate signal and transmit the received driving signal to the gate chip-on-film. The gate chip-on-film and the gate connection FPCB are disposed along different sides of the radiation detector.

The gate connection FPCB may be disposed along a side of the detector panel that is the same as a side on which the readout circuit is disposed.

The gate chip-on-film may be disposed along one side of the radiation detector, and the gate connection FPCB and the readout circuit may be disposed together along a side adjacent to the one side of the radiation detector on which the gate chip-on-film is disposed.

The readout circuit may be formed of a readout chip-on-film.

The radiation detector may be formed as a flexible detector.

A radiation detector includes a TFT array including a plurality of pixel TFT circuits, each of which generates an output signal according to intensity of detected X-rays, a gate circuit configured to apply a gate signal for driving the pixel TFT circuits to the TFT array, and a readout circuit configured to read the output signals and transmit the read output signals to an external device. The gate circuit includes a gate connection circuit receiving a driving signal from an external device, and a gate signal generation circuit receiving the driving signal from the gate connection circuit and generating the gate signal. The TFT array may be configured to form a quadrangular area. The gate connection circuit and the readout circuit are disposed together along one side of the quadrangular area of the TFT array, and the gate signal generation circuit is disposed along a side adjacent to the one side of the quadrangular area in which the gate connection circuit and the readout circuit are disposed.

The gate connection circuit may be formed in the form of an FPBC, and the readout circuit and the gate signal generation circuit may each be formed in the form of a chip-on-film.

A radiation detector for detecting radiation includes a flexibility detector panel extending in a first direction and detecting radiation incident on a first surface, a support member that is positioned on a second surface opposite to the first surface of the detector panel, supports the detector panel, and controls bending of the detector panel relative to a bending axis that is parallel to a second direction crossing the first direction, and a front protection unit that is positioned at the detector panel in a third direction to protect the detector panel, has a larger area than the exposed detector panel to cover the detector panel, has at least a portion fixed to the support member, is formed integrally, has flexibility, and is attachable to and detachable from the detector panel.

A material of the front protection unit of the radiation detector of the present invention may be a thin plate having radiation transmittance and resilience, and a thickness of the front protection unit may be 0.1 T or more and 1 T or less.

An upper fixing part may be formed to protrude upward from an upper surface of the front protection unit of the radiation detector of the present invention, a lower fixing part may be formed to protrude downward from a lower surface of the front protection unit, the upper fixing part and the lower fixing part may be screw-coupled to the support member, and holes formed in the upper and lower fixing parts may be circular holes different from long holes extending leftward and rightward.

The radiation detector of the present invention may include a fixing bracket that has at least a portion positioned at one or more of the support member and the front protection unit in the third direction, covers at least a portion of one side of the front protection unit, and is fixed to the support member, and the fixing bracket may include a protective cover for covering at least a portion of one side of the front protection unit, a fixing bracket frame that is coupled to the protective cover in a first direction and is in surface contact with the support member so that the fixing bracket does not shake with respect to the support member, and a fixing bracket fixing part that is coupled to the fixing bracket frame in a second direction, has a surface perpendicular to the fixed bracket frame, and coupled to at least one of a lower surface and an upper surface of the support member.

One side surface of the protective cover of the radiation detector of the present invention may be formed concavely in a third direction with respect to one side of the fixed bracket frame, and a height between one side of the protective cover and one side of the fixed bracket frame may be greater than or equal to a thickness of the front protective cover.

When the support member of the radiation detector of the present invention is unfolded, a space may be formed between an end of one side of the front protection unit and the fixed bracket frame in the first direction, and as the support member is bent, the space between the end of one side of the front.

At least one left fixing part may be formed on a left side of the front protection unit of the radiation detector of the present invention to protrude leftward, at least one right fixing part may be formed at a right side of the front protection unit to protrude to the right side, the right fixing part and the left fixing part may be screw-coupled to the support member, and the left fixing part and the right fixing part may have long holes extending leftward and rightward.

The radiation detector of the present invention may include a fixing bracket that has at least a portion positioned at one or more of the support member and the front protection unit in a third direction, covers at least a portion of one side of the front protection unit, and is fixed to the support member, the fixing bracket may extend the first direction and include an upper fixing bracket and a lower fixing bracket, the upper fixing bracket may include an upper separation prevention part that protrudes downward to prevent detachment of the front protection unit, and the lower fixing bracket may include a lower separation prevention part that protrudes upward to prevent detachment of the front protection unit.

At least some of four sides of the front protection unit of the radiation detector of the present invention may include a magnetic coupling unit including a magnet or a metal material having magnetism, and the magnetic coupling unit of the front protection unit may be coupled to a magnet or a metal material having magnetism of the support member so that the front protection unit is coupled to the support member.

The radiation detector of the present invention may include a magnetic coupling unit that has a magnet or a metal material having magnetism, has a shape formed along four sides of the front protection unit with a hole at a center thereof, and is positioned at the front protection unit in the third direction and coupled to a magnet or a metal material having magnetism of the support member to couple the front protection unit to the support member.

The front protection unit of the radiation detector of the present invention may include front protection unit connection units positioned at one or more of the upper left side, upper right side, lower left side, and lower right side, and front protection unit fixing units that are coupled to the front protection unit connection units, couple the front protection units to the support member, and have a surface that is perpendicular to the front protection unit, and the front protection unit fixing units may have at least one long hole formed extending leftward and rightward.

### [Advantageous Effects]

According to the present invention, a displacement difference occurring between a detector panel and front and rear protection panels when the detector panel and the front and rear protection panels are bent together can be absorbed, thereby realizing stable bending of a radiation detector.

According to the present invention, by spatially separating a gate connection flexible printed circuit board (FPCB) from a gate chip-on-film and arranging the gate connection FPCB along a side of a thin film transistor (TFT) radiation detector that is the same as a side on which a readout chip-on-film is disposed, parts can be disposed without interference when printed circuit boards are designed, and a miniaturized design of the radiation detector is possible.

Further, by spatially separating a relatively long gate connection FPCB from a relatively short gate chip-on-film and positioning the relatively long gate connection FPCB along another side, a length of a portion extending outward from a TFT X-ray detector in a direction in which the gate chip-on-film is formed can be minimized, thereby allowing a TFT radiation detector to be brought into maximum close contact with an object such as a pipe and enabling effective imaging.

### [Description of Drawings]

FIG. 1 is a schematic perspective view of a radiation detector according to one embodiment of the present invention.
FIG. 2 is a perspective view illustrating a bent state of the radiation detector according to one embodiment of the present invention.
FIG. 3 is an exploded perspective view of the radiation detector according to one embodiment of the present invention.

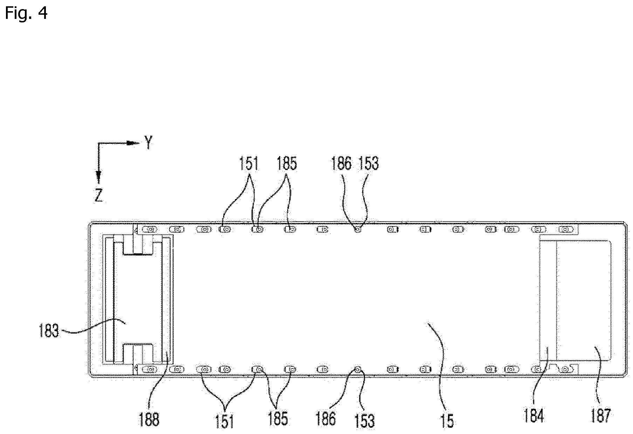

FIG. 4 is a plan view illustrating a state in which a rear cover and a rear protection panel are sequentially disposed on a rear support member of the radiation detector according to one embodiment of the present invention.
FIG. 5 is a plan view illustrating a state in which a detector panel is disposed on the rear protection panel of FIG. 4.

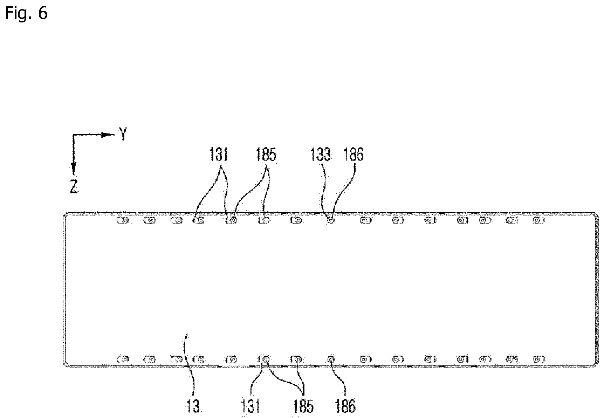

FIG. 6 is a plan view illustrating a state in which a front protection panel is disposed on the detector panel of FIG. 5.
FIG. 7 is a cross-sectional perspective view illustrating a movable support block of the radiation detector according to one embodiment of the present invention.
FIG. 8 is a cross-sectional view schematically illustrating a direct conversion type detector panel according to one embodiment of the present invention.
FIG. 9 is a cross-sectional view schematically illustrating an indirect conversion type detector panel according to another embodiment of the present invention.
FIG. 10 is a schematic view illustrating the detector panel according to one embodiment of the present invention.
FIG. 11 is a front view illustrating a radiation detector according to one embodiment of the present invention.
FIG. 12 is an exploded perspective view illustrating the radiation detector according to one embodiment of the present invention.
FIG. 13 is a view for describing a fixing bracket according to one embodiment of the present invention.
FIG. 14 is a view for describing the fixing bracket according to one embodiment of the present invention.
FIG. 15 is a view for describing a front protection unit according to one embodiment of the present invention.
FIG. 16 is a view for describing a front protection unit according to one embodiment of the present invention.
FIG. 17 is a view for describing a front protection unit according to one embodiment of the present invention.
FIG. 18 is a view for describing a front protection unit according to one embodiment of the present invention.
FIG. 19 is a view for describing a connection of a support member and a front protection unit according to one embodiment of the present invention.
FIG. 20 is a view for describing an additional example of the front protection unit according to one embodiment of the present invention.
FIG. 21 illustrates views for describing a screw connection according to one embodiment of the present invention.
FIG. 22 illustrates views for describing a front protection unit according to one embodiment of the present invention.
FIG. 23 illustrates views for describing a front protection unit according to one embodiment of the present invention.
FIG. 24 illustrates views for describing a front protection unit according to one embodiment of the present invention.
FIG. 25 is a block diagram illustrating a communication unit according to one embodiment of the present invention.
FIG. 26 illustrates views illustrating examples related to installation type of a wireless module according to one embodiment of the present invention.

### [Best Mode of the Invention]

Advantages and features of disclosed embodiments and methods of achieving the same will be clearly understood with reference to the accompanying drawings and embodiments described in detail below. However, the present invention is not limited to the embodiments to be disclosed below and may be implemented in various different forms. The embodiments are provided in order to fully explain the present embodiments and fully explain the scope of the present invention for those skilled in the art.

Terms used in this specification will be briefly described, and the disclosed embodiments will be described in detail.

Although the terms used herein are selected from among general terms that are currently and widely used in consideration of functions in embodiments of the present invention, these may be changed according to the intentions of those skilled in the art, precedents, or the advent of new technology. In addition, in a specific case, some terms may be arbitrary selected by applicants. In this case, meanings thereof will be described in detail in a corresponding description of embodiments of the present invention. Therefore, the terms used herein should be defined based on the meanings of the terms and content of this entire specification, rather than simply the terms themselves.

As used herein, the singular forms "a" and "an" are intended to also include the plural forms, unless the context clearly indicates otherwise. Further, the plural forms are intended to also include the singular forms, unless the context clearly indicates otherwise.

Throughout this specification, when a part "includes" an element, another element may be further included, rather than excluding the presence of the other element, unless otherwise described.

Further, the term "unit" described in the specification refers to software or a hardware component such as a field-programmable gate array (FPGA) or an applicationspecific integrated circuit (ASIC), and the unit performs certain functions. However, the "unit" is not limited to software or hardware. The "unit" may reside in an addressable storage medium or may be configured to regenerate at least one processor. Therefore, examples of the "unit" include components such as software components, object-oriented software components, class components and task components, and processes, functions, attributes, procedures, subroutines, segments of program code, drivers, firmware, micro code, circuits, data, databases, data structures, tables, arrays, and variables. Components and functions provided in "units" may be combined into a smaller number of components and "units" or may be further separated into additional components and "units."

According to an embodiment of the present invention, "unit" may be implemented with a processor or a memory. The term "processor" should be interpreted broadly to include a general purpose processor, a central processing unit (CPU), a microprocessor, a digital signal processor (DSP), a controller, a microcontroller, a state machine, or the like. In some environments, the "processor" may refer to an ASIC, a programmable logic device (PLD), a FPGA, or the like. The term "processor" may refer to, for example, combinations of processing devices, such as a combination of a DSP and a microprocessor, a combination of a plurality of microprocessors, a combination of one or more microprocessors in combination with a DSP core, and a combination of any other such components.

The term "memory" should be interpreted broadly to include any electronic component that can store electronic information. The term "memory" may refer to any of various types of processor-readable media, such as a random-access memory (RAM), a read-only memory (ROM), a non-volatile random-access memory (NVRAM), a programmable read-only memory (PROM), an erase-programmable read-only memory (EPROM), an electrically erasable PROM (EEPROM), a flash memory, a magnetic or optical data storage, a register, and the like. When a processor is capable of reading information from and/or writing information to a memory, the memory is determined to be in electronic communication with the processor. A memory integrated in a processor is in electronic communication with the processor.

Hereinafter, embodiments of the present invention that may be easily performed by those skilled in the art will be described in detail with reference to the accompanying drawings. However, embodiments of the present invention may be implemented in several different forms and are not limited to embodiments described herein.

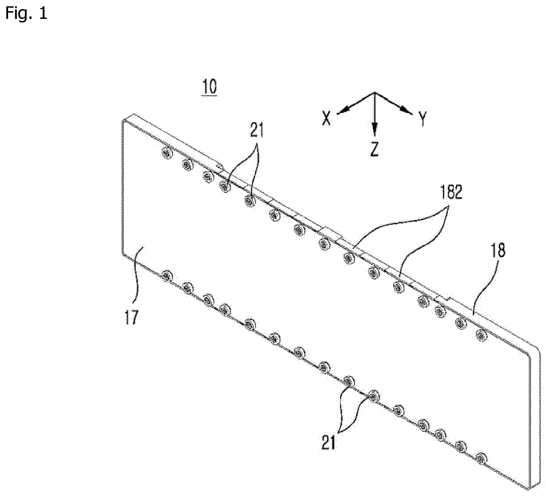

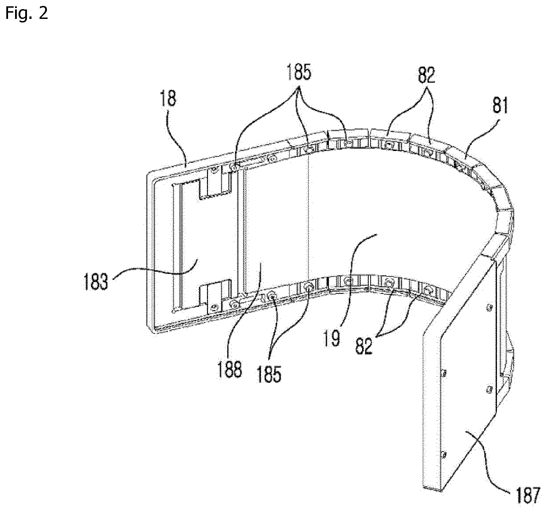

Referring to FIGS. 1 and 2, a radiation detector 10 according to one embodiment of the present invention is configured to detect radiation and output a corresponding signal. For example, the radiation detector 10 may be a radiation detector that generates an electrical signal according to incident X-rays, and for example, the radiation detector may be a direct conversion type radiation detector that directly converts photons of X-rays into electric charges or an indirect conversion type radiation detector that converts X-rays into visible light and then converts photons of the visible light into electric charges. Further, as is generally known, a radiation detector may include a thin film transistor (TFT) array including a plurality of pixel TFT circuits that generate electrical signals according to an amount of generated electric charges. The structure and principle for implementing the basic function of such a radiation detector are widely known in the art to which the present invention pertains, and thus a more detailed description thereof will be omitted.

The radiation detector 10 is formed to be bendable as illustrated in FIG. 2, and to this end, portions constituting the radiation detector 10 are formed of a bendable material or with a bendable structure. Further, the radiation detector 10 according to one embodiment of the present invention may be bent in a direction opposite to a bending direction illustrated in FIG. 2, and this means that the radiation detector 10 according to one embodiment of the present invention may be bent in two directions. To aid understanding of the present invention, FIG. 2 illustrates the radiation detector 10 from which some components are removed.

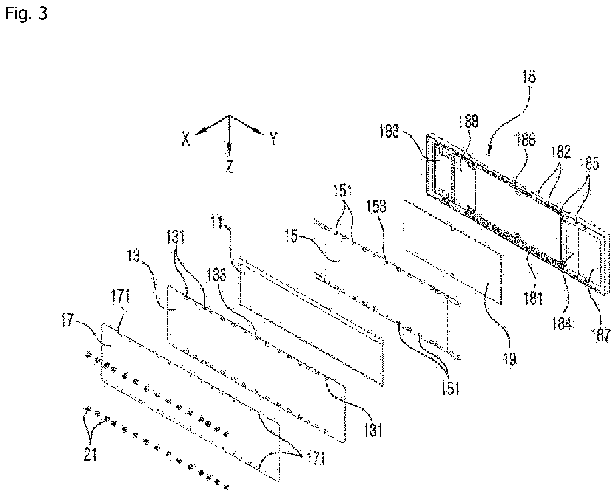

Referring to FIG. 3, the radiation detector 10 includes a detector panel 11. For example, the detector panel 11 is configured to generate an electrical signal according to X-rays incident directly or indirectly as described above. Specifically, when the detector panel 11 is a direct conversion type radiation detector, the detector panel 11 may include a photoconductor layer in which electric charges are generated by incident X-rays, and a TFT array including a plurality of pixel TFT circuits that collect the electric charges generated in the photoconductor layer. Meanwhile, when the detector panel 11 is formed in an indirect conversion type, the detector panel 11 may include a scintillator layer, a photodiode layer, and a TFT array.

The detector panel 11 may be formed to have a substantially quadrangular shape and include a gate circuit for applying a signal for driving the switching of the pixel TFT circuit, and a readout circuit for receiving an output signal of the pixel TFT circuit and outputting the output signal to an outside thereof. For example, the gate circuit and the readout circuit may be disposed at adjacent sides of the detector panel 11.

As described above, the detector panel 11 may be formed to be bendable in two directions, and to this end, the detector panel 11 may be manufactured by forming the above-described TFT array on a substrate made of a bendable synthetic resin material.

A front protection panel 13 and a rear protection panel 15 are disposed at both sides of the detector panel 11. The front protection panel 13 is disposed at a front side of the detector panel 11, that is, a side at which radiation to be detected is incident, and the rear protection panel 15 is disposed at a side opposite thereto. Since radiation, for example, X-rays, are incident on the detector panel 11 through the front protection panel 13, the front protection panel 13 may be formed of a material that allows X-rays to pass therethrough. Further, as described above, not only the detector panel 11, but also the front protection panel 13 and the rear protection panel 15 are formed of a bendable material that can be bent in two directions. The front protection panel 13 and the rear protection panel 15 may be disposed adjacent to the front and rear of the detector panel 11 and configured to perform a function of protecting the detector panel 11 and at the same time, perform an electrical grounding function. For example, the front protection panel 13 and the rear protection panel 15 may be formed of aluminum.

The radiation detector 10 includes a support member 18 that supports the detector panel 11, the front protection panel 13, and the rear protection panel 15. That is, the detector panel 11, the front protection panel 13, and the rear protection panel 15 are supported by the support member 18 to form one module. In this case, the detector panel 11, the front protection panel 13, and the rear protection panel 15 are supported by the support member 18 to be bendable in two directions, and in particular, since the detector panel 11, the front protection panel 13, and the rear protection panel 15 that are disposed adjacently in a stacked form experience different displacements when bent, the detector panel 11, the front protection panel 13, and the rear protection panel 15 are bendable in two directions while allowing different displacements.

The support member 18 is also bendable in two directions together with the detector panel 11, the front protection panel 13, and the rear protection panel 15. As illustrated in FIG. 3, the support member 18 includes first and second supports 187 and 188 that are disposed to be spaced apart from each other, and a bendable bending part 181 that couples the first and second supports 187 and 188. The bending part 181 includes a plurality of connection members 182 that are sequentially coupled to allow hinge motion with respect to one another. The bending part 181 including the plurality of connection members 182 that allow hinge motion is bent as illustrated in FIG. 2 when an external force is applied.

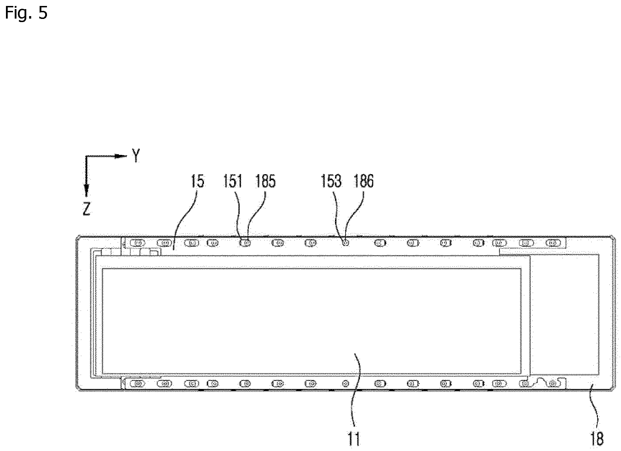

The support member 18 may include a fixed support block 184 and a movable support block 183 that are respectively installed on the first and second supports 187 and 188. Referring to FIGS. 3 and 5, one end portion of the detector panel 11 is fixed to the fixed support block 184 and the other end portion is fixed to the movable support block 183, and thus the detector panel 11 is supported by the support member 18.

The fixed support block 184 is fixedly fastened to the first support 187 so that the fixed support block 184 is fixed to the first support 187 even when the radiation detector 10 is bent, whereas the movable support block 183 is movably fastened to the second support 188 so that the movable support block 183 can move laterally, that is, in a Y-axis direction in FIG. 3, with respect to the second support 188. One edge of the detector panel 11, for example, an edge to which a readout circuit 1030 is coupled, may be fixed to the fixed support block 184.

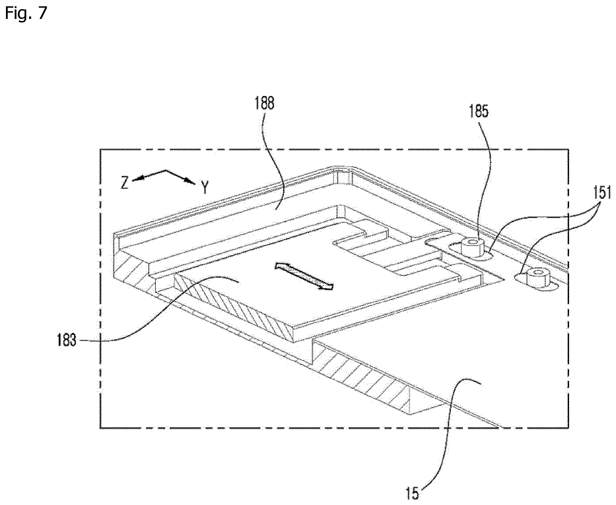

Accordingly, referring to FIGS. 2 and 7, when the radiation detector 10 is bent, the movable support block 183 moves in a direction of an arrow illustrated in FIG. 7. Accordingly, when the detector panel 11 is bent, displacement of one end portion of the detector panel 11 is possible together with the movement of the movable support block 183, and accordingly, a change in shape due to the bending of the detector panel 11 may be stably achieved.

A rear cover 19 that closes a space between the first support 187 and the second support 188 disposed on both sides of the support member 18 may be fixed to the support member 18. Accordingly, the rear cover 19 covers a rear surface of the rear protection panel 15. The rear cover 19 is also formed of a bendable material.

The front cover 17 is fastened to the support member 18 while being disposed in the front of the front protection panel 13, and the front protection panel 13 and the rear protection panel 15 are supported by the front cover 17 and the support member 18 while being disposed on both sides of the detector panel 11. In this case, the front protection panel 13 and the rear protection panel 15 are supported by the support member 18 in a manner where a difference in displacement between the front cover 17 and the support member 18 can be absorbed by the bidirectional bending.

The front cover 17 may be formed to have a rectangular ring shape similar to the shape of the support member 18 described above. The support member 18 may include a plurality of fastening rods 185 protruding forward from edge areas thereof, and each fastening rod 185 is inserted into a fastening hole 171 formed in the front cover 17. In this case, a plurality of fastening members 21 may be fastened to the fastening rods 185 to fix the front cover 17 to each fastening rod 185. The plurality of fastening rods 185 may be disposed in sequence along the edges of the first and second supports 187 and 188 and along the bending part 181, as illustrated in the drawing.

The front protection panel 13 is interposed between the front cover 17 and the detector panel 11, and the rear protection panel 15 is interposed between the support member 18 and the detector panel 11. In this case, the front protection panel 13 and the rear protection panel 15 are each supported by the fastening rod 185 that couples the front cover 17 and the support member 18.

The front protection panel 13 and the rear protection panel 15 include a plurality of fastening slots 131 and 151 formed in the edge areas, respectively. The fastening slots 131 and 151 of the front protection panel 13 and the rear protection panel 15 may be formed at positions corresponding to each other, and each fastening rod 185 passes through the overlapping fastening slots 131 and 151 of the front protection panel 13 and the rear protection panel 15. In this case, the fastening slot 131 of the front protection panel 13 and the fastening slot 151 of the rear protection panel 15 may be formed to be positioned outside an area occupied by the detector panel 11. Accordingly, the front protection panel 13 and the rear protection panel 15 are each supported by the fastening rod 185 that couples the front cover 17 and the support member 18.

In this case, the fastening rod 185 and the fastening slots 131 and 151 are configured so that relative movement of the fastening rod 185 is restricted one direction and allowed in another direction. For example, the fastening rod 185 and the fastening slots 131 and 151 are configured so that movement of the fastening rod 185 is substantially restricted within the fastening slots 131 and 151 in a Z-axis direction and allowed within the fastening slots 131 and 151 in a Y-axis direction. Here, the Y-axis direction may be defined as a width direction of the detector panel 11 and the Z-axis direction may be defined as a height direction of the detector panel 11. To this end, the fastening slots 131 and 151 may have a shape of a long hole having a greater length in the Y-axis direction than that in the Z-axis direction, and the fastening rod 185 may have a circular cross-section having a diameter that is substantially the same as the length in the Z-axis direction of the fastening slots 131 and 151. Since the fastening rods 185 that are fixed to the front cover 17 and the support member 18 is inserted into the long hole fastening slots 131 and 151 of the front protection panel 13 and the rear protection panel 15, the fastening rods 185 may move in the long direction of the fastening slots 131 and 151 when the detector panel 11, the front and rear protection panels 13 and 15, the front cover 17, and the support member 18 are bent around a direction parallel to the Z-axis as illustrated in FIG. 2, and thus a difference in displacement between the detector panel 11, the front and rear protection panels 13 and 15, the front cover 17, and the support member 18 due to bending may be absorbed, thereby enabling stable bending. Further, the lengths of the fastening slots 131 and 151 may be adjusted to achieve a desired range of bending.

Meanwhile, in order to set a reference point of bending when the detector panel 11, the front and rear protection panels 13 and 15, the front cover 17, and the support member 18 are bent together, movement-limiting fastening slots 133 and 153 may be respectively formed at corresponding positions of the front protection panel 13 and the rear protection panel 15. The movement-limiting fastening slots 133 and 153 do not have a long hole shape but have a shape substantially identical to the shape of movement-limiting fastening rods 186. Accordingly, the movement-limiting fastening rods 186 inserted into the movement-limiting fastening slots 133 and 153 are blocked from moving in both the Z-axis direction and the Y-axis direction. Accordingly, when the detector panel 11, the front protection panel 13, and the rear protection panel 15 are bent, the front protection panel 13 and the rear protection panel 15 are fixed to the support member 18 at the positions of the movement-limiting fastening slots 133 and 153. In this aspect, it can be said that the movement-limiting fastening slots 133 and 153 form a reference point for the bending of the detector panel 11, the front protection panel 13, and the rear protection panel 15. Although examples of the positions of the movement-limiting fastening slots 133 and 153 and the movement-limiting fastening rods 186 inserted therein are illustrated in the drawing, the positions of the movement-limiting fastening slots 133 and 153 and the movement-limiting fastening rods 186 may be changed as necessary.

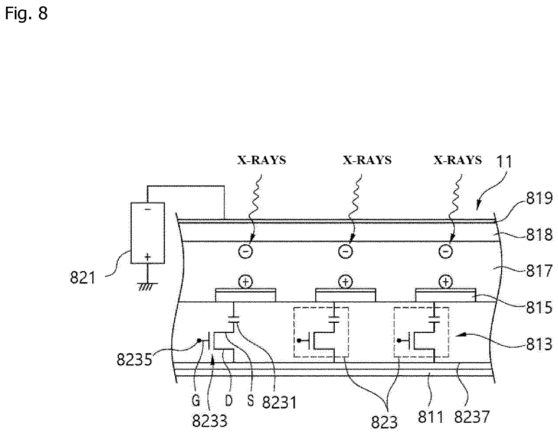

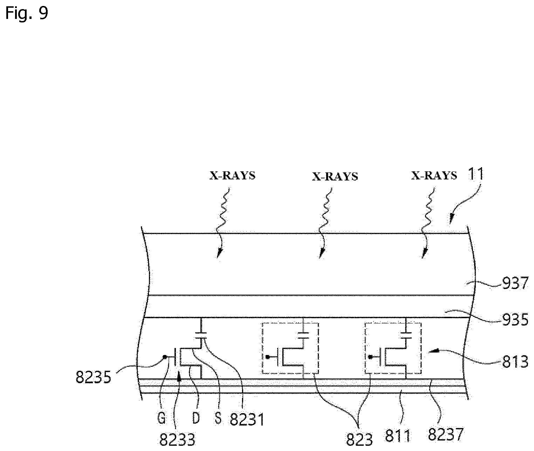

As described above, the radiation detector 10 according to one embodiment of the present invention may be a direct or indirect conversion type radiation detector. An example of a direct conversion type radiation detector 10 is illustrated in FIG. 8, and an example of an indirect conversion type radiation detector 10 is illustrated in FIG. 9.

Referring to FIG. 8, the radiation detector 10 according to one embodiment of the present invention may be a digital radiation detector that directly converts photons of X-rays into electric charges, that is, a direct conversion type radiation detector. Further, the radiation detector 10 according to one embodiment of the present invention may be a flexible radiation detector that can be bent.

The radiation detector 10 may include a detector panel 11. FIG. 8 illustrates a cross-section of the detector panel 11. Referring to FIG. 8, in the radiation detector panel 11 according to one embodiment of the present invention, a TFT array 813, an electric charge collection unit 815, a photoconductor layer 817, and an upper electrode 819 may be sequentially formed on a substrate 811 that can be bent. For example, the substrate 811 may be formed of a bendable synthetic resin material, and thus the radiation detector 10 according to one embodiment of the present invention may be formed as a flexible detector. Further, the detector panel 11 included in the radiation detector 10 may be a flexible panel.

When X-rays are incident on the upper electrode 819 while a high voltage of a power source 821 is applied, the photoconductor layer 817 generates electric charges. The photoconductor layer 817 may be formed of a material that directly converts photons of X-rays into electric charges, that is, a photoconductor, such as amorphous selenium, lead oxide (PbO), mercury iodide (HgI₂), thallium bromide, etc. In this case, an electrical insulation layer 818 is formed between the upper electrode 819 and the photoconductor layer 817, and thus the upper electrode 819 and the photoconductor layer 817 may be electrically insulated from each other.

The TFT array 813 may include a plurality of pixel TFT circuits 823 and may be formed in the form of a flexibility panel. As is generally known, the plurality of pixel TFT circuits 823 may be disposed in the form of a matrix in units of pixels, thereby allowing the TFT array 813 to form a quadrangular area. Each pixel TFT circuit 823 includes a storage capacitor 8231 and a TFT switching element 8233. The TFT switching element 8233 includes a gate terminal G, a data terminal D, and a source terminal S, and the source terminal S is coupled to the storage capacitor 8231. The gate terminal G is signal-coupled to a gate circuit, that is, a gate chip-on-film (COF) 1011, through a gate line 8235, and the data terminal D is signal- coupled to a readout circuit, that is, a readout integrated circuit (IC) COF 1030, through a data line 8237.

When electric charges are generated in the photoconductor layer 817 by incident X-rays, positive electric charges among the generated electric charges are collected in the electric charge collection unit 815. Furthermore, the position electric charges collected in the electric charge collection unit 815 are stored in the storage capacitor 8231 of the pixel TFT circuit 823. Since an amount of electric charges generated by the photoconductor layer 817 in this process varies according to the intensity of the incident X-rays, the amount of electric charges stored in the storage capacitor 8231 as a result varies depending on the intensity of the X-rays. When a gate signal, that is, a scan signal, is applied to the gate terminal G through the gate line 8235, the TFT switching element 8233 is turned on, and thus an output signal corresponding to the amount of electric charges stored in the storage capacitor 8231 is output to the data line 8237 through the data terminal D. An output signal corresponding to the intensity of X-rays detected for each pixel is output in this way, and this output signal may be used to generate an X-ray image. Meanwhile, although not illustrated in the drawing, as is generally known, a circuit element for initializing the storage capacitor 8231 after outputting the output signal by turning on the TFT switching element 8233, for example, a switching element, may be coupled to the storage capacitor 8231 in parallel.

Meanwhile, referring to FIG. 9, the radiation detector 10 according to another embodiment of the present invention may be an indirect conversion type digital radiation detector that converts X-rays into visible light and then changes photons of the visible light into electric charges. For example, the radiation detector 10 may include an indirect conversion type detector panel 11. The same portions as the direct conversion type radiation detector described above with reference to FIG. 8 are used with the same drawing reference numerals and the description thereof will not be repeated.

Referring to FIG. 9, the indirect conversion type radiation detector 10 includes a scintillator layer 937 that converts incident X-rays into visible light, and a photodiode layer 935 that generates electric charges in the visible light converted by the scintillator layer 937. The scintillator layer 937 may be formed as a scintillator that emits visible light proportional to incident X-rays. The photodiode layer 935 may be formed as an amorphous silicon photodiode and converts visible light emitted from the scintillator layer 937 into electric charges. As in the previously described embodiment, the electric charges generated in the photodiode layer 935 are detected by a TFT array 813.

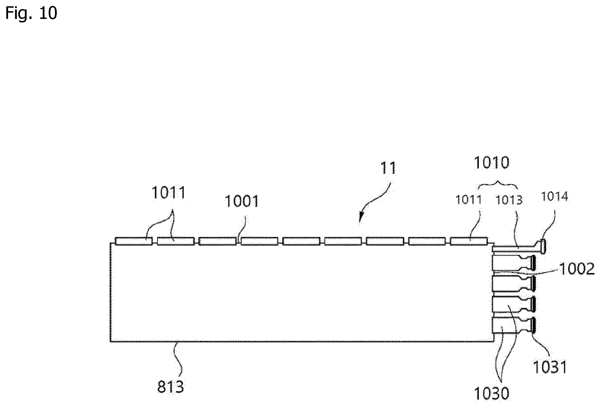

Hereinafter, a gate circuit 1010 for applying a gate signal to a gate line 8235, and a readout circuit 1030 for receiving an output signal from a data line 8237 and outputting the received output signal to an outside thereof will be described with reference to FIG. 10.

FIG. 3 illustrates a plan view of the TFT array 813 of the radiation detector 10, and the entirety of the TFT array 813 may have a quadrangular shape. As described above, the TFT array 813 includes a plurality of pixel TFT circuits 823 arranged in the form of a matrix.

The gate circuit 1010 is configured to apply a gate signal to the gate line 8235 coupled to the pixel TFT circuit 823. According to the embodiment of the present invention, the gate circuit 1010 is divided into two parts, that is, a gate COF 1011 and a gate connection flexible printed circuit board (FPCB) 1013, and the gate COF 1011 and the gate connection FPCB 1013 are respectively disposed along different sides 1001 and 1002 of the radiation detector panel 11. Here, the sides of the radiation detector panel 11 may also be understood as the sides of a quadrangular area of the TFT array 813. The gate connection FPCB 1013 is signal-coupled to an external controller through a connector 1014, receives a driving signal from the external controller, and transmits the received driving signal to the gate COF 1011, and the gate COF 1011 generates a gate signal according to the received driving signal and applies the generated gate signal to the gate line 8235.

The readout circuit 1030 is implemented in the form of a COF, and therefore, the readout circuit 1030 may be called a readout COF. The readout COF 1030 is coupled to an external image signal processing unit through a connector 1031 and transmits an output signal to the image signal processing unit.

According to the embodiment of the present invention, the readout COF 1030 may be disposed along one side of the detector panel 11. In this case, the gate COF 1011 of the gate circuit 1010 may be disposed along one side 1001 of the detector panel 11 having a quadrangular shape, and the gate connection FPCB 1013 of the gate circuit 1010 and the readout COF 1030 may be disposed along a side 1002 adjacent to the side 1001 of the detector panel 11 on which the gate COF 1011 is disposed. According to the embodiment of the present invention, considering that the gate connection FPCB 1013 and the readout COF 1030 should be formed relatively long in order to be signal-coupled to an external controller or image signal processing unit and should include the connectors 1014 and 1031 for connection, the gate connection FPCB 1013 and the readout COF 1030 may be disposed on the same side 1002 so that the size of the detector panel 11 in a height direction, that is, in a vertical direction in FIG. 10, may be significantly reduced. Accordingly, since the gate COF 1011 forms a portion protruding outward from the TFT array 813 in the height direction of the detector panel 11, the length in the height direction of the portion protruding outward from the TFT array 813, which is an X-ray detection area, can be minimized. This means that the radiation detector 10 including the detector panel 11 may approach a target very closely in the height direction, thereby enabling imaging to be performed with the radiation detector 10 positioned very close to a connection part of a T-shaped pipe. Further, the gate COF 1011 and the gate connection FPCB 1013 may be disposed along different sides of the radiation detector and thus can be prevented from interfering with each other.

Although an example of the direct conversion type radiation detector has been described above, it can be recognized that the present invention may also be applied to an indirect conversion type radiation detector having a TFT array. Further, the radiation detector according to one embodiment of the present invention may be implemented as a flexible detector that can be bent as described above, or may be a rigid type radiation detector in which a TFT is formed on a glass substrate.

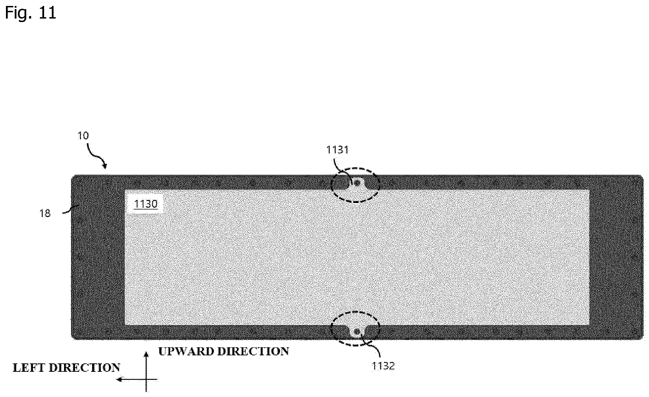

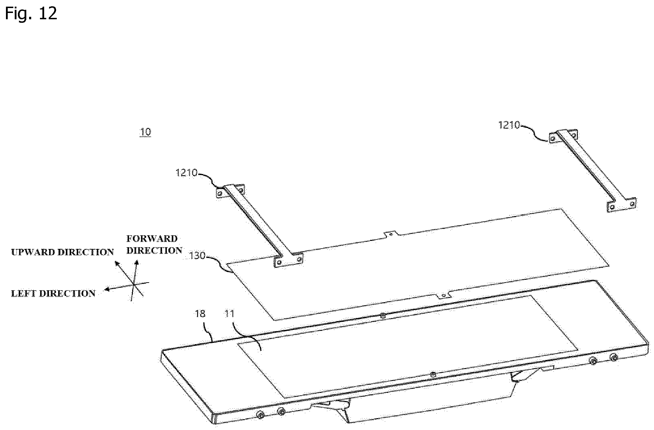

FIG. 11 is a front view illustrating a radiation detector according to one embodiment of the present invention. FIG. 12 is an exploded perspective view illustrating the radiation detector according to one embodiment of the present invention.

Hereinafter, the radiation detector will be described with reference to FIGS. 11 and 12.

The radiation detector 10 of the present invention may be a device that detects radiation emitted from a radiation source and transmitted through a subject. The radiation may include at least one of X-rays, gamma rays, and some ultraviolet rays. The radiation detector 10 may detect the radiation to obtain a radiographic image of the subject. For example, the radiographic image obtained by the radiation detector 10 may include at least one of an X-ray image and a computed tomography (CT) image.

The radiation detector 10 may include a detector panel 11. The detector panel may be divided into a indirect conversion type detector panel that uses a scintillator to obtain an electric signal indirectly from visible light, and a direct conversion type detector panel that uses photoconductors to obtain an electric signal directly from radiation, depending on a method of obtaining the electric signal, or may be divided into a charge-coupled device (CCD) type detector panel that uses a CCD, a complementary metal-oxide-semiconductor (CMOS) type detector panel that uses a crystalline silicon CMOS device, and an a-Si type detector panel that uses an amorphous silicon TFT substrate, depending on the type of device that generates the electric signal.

The radiation detector 10 including the detector panel 11 may be equipped with various sensors to realize digital image data with the electric signal and position information of the sensor proportional to the amount of radiation incident. The radiation detector 10 may obtain photographing results close to real time and secure high resolution and a wide dynamic range with relatively little radiation, and due to the nature of digital data, storage and processing of the photographing results are easy. The radiation detector 10 includes a readout signal unit that reads an electrical signal output from a pixel array, a gate driver that turns on a switching element so that the readout signal unit can read the electrical signal, and the like, and the electrical signal detected by the readout signal unit is converted into an image signal through a certain processing process in a controller equipped on a main board and then transmitted to a display device for displaying an X-ray image.

The radiation detector 10 may include at least one of a pixel array, a readout signal unit, a gate driver circuit unit, and a main board. The readout signal unit may be implemented with a plurality of readout ICs (ROICs) in the form of a film, and each ROIC may be coupled to the main board by a connector.

The radiation detector 10 may include a photodetector that detects X-rays and generates an electric signal, and a readout circuit unit that reads the generated electric signal. The control unit may process the electric signal output from the readout circuit unit and then generate X-ray image data that forms an X-ray image. The generated X-ray image data may be stored in a storage unit together with (or separately from) detector state information or information related to X-ray photography.

In order for the radiation detector 10 to sequentially perform operations of detecting X-ray information and transmitting the detected X-ray information to an external computer, the radiation detector 10 may use a power and data cable through which power supply and data communication are performed together.

Further, the radiation detector 10 may use Wi-Fi and Gigabit Ethernet for wired and wireless data transmission. Further, the control unit of the radiation detector 10 may be coupled to and communicate with a workstation for variables for driving an image sensor, and the like.

The detector panel 11 may extend in a first direction. In FIG. 11, the first direction may be a left direction. However, the present invention is not limited thereto, and the first direction may be a right direction. The detector panel 11 may detect radiation incident on a first surface. Here, the first surface may be a front surface of the detector panel 11. The detector panel 11 may have flexibility. That is, the detector panel is flexible and may be bent. When a surface of a subject has a round surface, the detector panel 11 may be bent and brought into close contact with the surface of the subject. Since the detector panel 11 is positioned to be brought into close contact with the surface of the subject, the sharpness of a radiographic image can be improved.

The radiation detector 10 may include a bending support member 18. In FIG. 11, a rear protection panel 15 and a rear cover 19 are not illustrated, but at least one of the rear protection panel 15 and the rear cover 19 may be positioned between the support member 18 and the detector panel 11.

The support member 18 may be brought into contact with a second surface opposite to the first surface of the detector panel 11. The second surface may be a rear surface of the detector panel 11. The support member 18 may support the detector panel 11. As described above, the detector panel 11 is flexible and may be bent, and thus when there is no support member 18, it may be difficult to keep the detector panel 11 still with respect to the subject. This is because the detector panel 11 will easily be deformed by the movement of the subject or an external force. Therefore, the support member 18 may be a component for supporting the detector panel 11 so that the detector panel 11 is maintained in a certain shape after being bent. The support member 18 may adjust the bending of the detector panel 11 around a bending axis that is parallel to a second direction crossing the first direction. That is, the detector panel 11 may also be bent as much as the support member 18 is bent. Here, the second direction may be an upward direction. However, the present invention is not limited thereto and the second direction may be a downward direction.

The support member 18 may include various components for the operations of the radiation detector 10. For example, the support member 18 may include at least one of a control unit, a communication unit, an input unit, and an output unit for the operations of the radiation detector 10. Further, as illustrated in FIG. 12, the detector panel 11 may be embedded in the support member 18. However, the present invention is not limited thereto.

The radiation detector 10 may include a front protection unit 1130. The front protection unit 1130 may be positioned at the detector panel 11 in a third direction to protect the detector panel 11. Here, the third direction may be a forward direction.

The front protection unit 1130 may have a greater area than the detector panel 11 exposed from the support member 18 to cover the detector panel 11. At least a portion of the front protection unit 1130 may be fixed to the support member 18. The front protection unit 1130 may not be fixed to the detector panel 11. Further, only a portion of the front protection unit 1130 may be coupled to the support member 18. Therefore, the front protection unit 1130 may secure flexibility, and the front protection unit 1130 not only may protect the detector panel 11, but also prevent damage to the support member 18 and the detector panel 11. The fixing of the front protection unit 1130 and the support member 18 will be described in detail below.

Further, the front protection unit 1130 may be formed integrally. That is, the front protection unit 1130 may have a shape of a single panel different from a shape of various components combined. For example, the front protection unit 1130 may be manufactured by cutting or folding a single plate of a predetermined material. However, the present invention is not limited thereto.

The front protection unit 1130 may have flexibility. Therefore, the front protection unit 1130 may also be bent according to the bending of at least one of the detector panel 11 and the support member 18. Further, the front protection unit 1130 may be attachable to and detachable from the detector panel 11.

The detector panel 11 may already be covered with a housing for protecting the detector panel 11. Therefore, the detector panel 11 may also be protected from external impact by the housing. The front protection unit 1130 may be an additional unit for protecting the detector panel 11 in addition to the housing. The housing for protecting the detector panel 11 may include at least one of a front protection panel 13 and a front cover 17. The front protection unit 1130 may be a component additionally used to the front protection panel 13 and the front cover 17. The front protection unit 1130 may be disposed on a front surface of the front cover 17. However, the present invention is not limited thereto, and the front protection unit 1130 may replace at least one of the front protection panel 13 and the front cover 17. That is, the radiation detector may include the front protection unit 1130 without including at least one of the front protection panel 13 and the front cover 17.

Hereinafter, the front protection panel 13 and the front cover 17 are omitted in order to focus on the front protection unit 1130, but it should be understood that at least one of the front protection panel 13 and the front cover 17 may be positioned between the front protection unit 1130 and the detector panel 11.

The housing for protecting the detector panel 11 is bonded to the detector panel 11, and thus when there is a problem with a material of for protecting the detector panel 11, the detector panel 11 may need to be replaced. In particular, when the subject is a rough object or the radiation detector 10 is used in a tough environment, the detector panel 11 is more likely to be damaged, and thus a replacing cycle for the radiation detector 10 may be short. The radiation detector 10 of the present invention includes a replaceable front protection unit 1130, and the front protection unit 1130 may be brought into contact with or approach the subject instead of the detector panel 11. Therefore, scratches may not occur on the detector panel 11 but on the front protection unit 1130, and the user may easily maintain the radiation detector 10 by simply only replacing the front protection unit 1130. That is, the radiation detector 10 of the present invention includes an attachable and detachable front protection unit 1130, and thus the durability of the radiation detector 10 may be further improved.

A thickness of the front protection unit 1130 may be 0.1 T or more and 1 T or less. Further, the material of the front protection unit 1130 may be a material that transmits radiation. Further, the material of the front protection unit 1130 may be a material that has resilience, and may be a material that can be restored to its original state even when the material is bent by an external force. When the thickness of the front protection unit 1130 exceeds 1.0 T, transmittance and resilience (yield strength) decrease, and thus it is difficult to use the front protection unit 1130 in a bendable radiation detector 10, and the quality of a radiographic image may decrease. Further, when the thickness of the front protection unit 1130 is less than or equal to 0.1 T, the front protection unit 1130 may not only fail to function as a protection unit, but also have poor durability. The front protection unit 1130 may have a transmittance of 85% or more. Further, when the front protection unit 1130 has a transmittance lower than 85%, high energy band radiation should be irradiated to obtain a radiographic image, which may have a negative effect on a circuit board provided in the detector due to excessive energy exposure, and the subject's radiation exposure may increase. When a front protection unit 1130 of 1T or more is used to protect the circuit board from excessive energy exposure, a problem in which the front protection unit 1130 may be damaged or may not be restored when bent may occur. Further, the yield strength of the front protection unit 1130 may be 20 MPa or more and 30 MPa or less. For example, the yield strength of the front protection unit 1130 may be 23 MPa. The front protection unit 1130 having such physical characteristics may maintain appropriate elasticity when bent and may enable repeated bending and flattening movements without affecting the TFT and circuit board of the radiation detector 10.

The material of the front protection unit 1130 may be at least one of stainless steel sheet material, copper sheet material, and carbon tool steel. However, the present invention is not limited thereto, and the material of the front protection unit 1130 may be a composite material sheet mixed with at least one of stainless steel material, copper material, and carbon tool steel. Carbon tool steel that can be used as the front protection unit 1130 may be one of SK1, SK2, SK3, SK4, SK5, SK6, and SK7. In order to increase the surface hardness of the front protection unit 1130, the material may be subjected to post-processing. For example, heat treatment, physical vapor deposition (PVD), diamond-like carbon (DLC) coating, or the like may be applied to the material. The front protection unit 1130 may be made of the above material and thickness to maintain bendability while returning to its original state. Further, since the front protection unit 1130 allows radiation to pass through, the front protection unit 1130 may have little effect on the radiographic image. Further, the front protection unit 1130 may secure strength sufficient to protect the detector panel 11. At least one of optimal bendability, restorability, and radiolucency of the front protection unit 1130 may be secured by the material and thickness of the front protection unit 1130 as described above, and this has been experimentally proven. Further, even when an external material applies force to the detector, only the front protection unit 1130 is damaged, and thus the same performance as a new detector may be maintained by replacing only the front protection unit 1130, thereby increasing user convenience.

Referring to FIG. 11, the front protection unit 1130 may include an upper fixing part 1131. Further, the upper fixing part 1131 may be formed to protrude upward from on an upper surface of the front protection unit 1130. The front protection unit 1130 may include a lower fixing part 1132. The lower fixing part 1132 may be formed to protrude downward from a lower surface of the front protection unit 1130. Holes may be formed in the upper fixing part 1131 and the lower fixing part 1132. The holes formed in the upper fixing part 1131 and the lower fixing part 1132 may be formed as circular holes different from long holes extending leftward and rightward. However, the present invention is not limited thereto. The upper fixing part 1131 and the lower fixing part 1132 may be screw-coupled to the support member 18. That is, the screw may pass through the upper fixing part 1131 and the lower fixing part 1132 and be coupled to the support member 18.

The upper fixing part 1131 and the lower fixing part 1132 may be positioned at the center of the front protection unit 1130. That is, distances from the upper fixing part 1131 and the lower fixing part 1132 to a left end of the front protection unit 1130 may be the same as distances from the upper fixing part 1131 and the lower fixing part 1132 to a right end of the front protection unit 1130. However, the present invention is not limited thereto.

The upper fixing part 1131 and the lower fixing part 1132 may prevent the front protection unit 1130 from moving away from one of the detector panel 11 and the support member 18. Further, since the upper fixing part 1131 and the lower fixing part 1132 are formed to protrude from the front protection unit 1130, deformation of the front protection unit 1130 can be minimized. For example, when force is applied to the front protection unit 1130, force may be applied to the fixed upper fixing part 1131 and lower fixing part 1132, and since deformation of the upper fixing part 1131 and the lower fixing part 1132 has little effect on the generation of a radiographic image, there may be no problem in using the radiation detector 10 even when deformation occurs in the upper fixing part 1131 and the lower fixing part 1132.

Further, by minimizing the combination of the front protection unit 1130 and the support member 18, damage to the radiation detector 10 that is caused by the front protection unit 1130 can be minimized. Because, as described above, the front protection unit 1130 may be brought into contact with and approach the subject and thus may receive a large external force. Since the external force is not transmitted to the detector panel 11 or the support member 18 through the front protection unit 1130, damage to the radiation detector 10 can be minimized.

Further, since the front protection unit 1130 is brought into close contact with the detector panel 11 by the upper fixing part 1131 and the lower fixing part 1132, the image of the radiation detector 10 may not be distorted by the front protection unit 1130.

Referring to FIG. 12, the radiation detector 10 may include a fixing bracket 1210. The fixing bracket 1210 may include a left fixing bracket 1210 and a right fixing bracket 1210. At least a portion of the fixing bracket 1210 may be positioned at one or more of the support member 18 and the front protection unit 1130 in a third direction. The third direction may mean a forward direction. The fixing bracket 1210 may cover at least a portion of one side of the front protection unit 1130. For example, the left fixing bracket 1210 may cover at least a portion of the left side of the front protection unit 1130. Further, the right fixing bracket 1210 may cover at least a portion of the right side of the front protection unit 1130. The fixing bracket 1210 may be fixed to the support member 18.

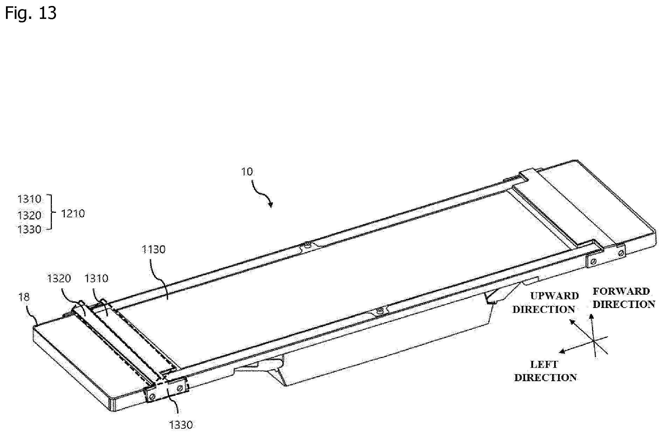

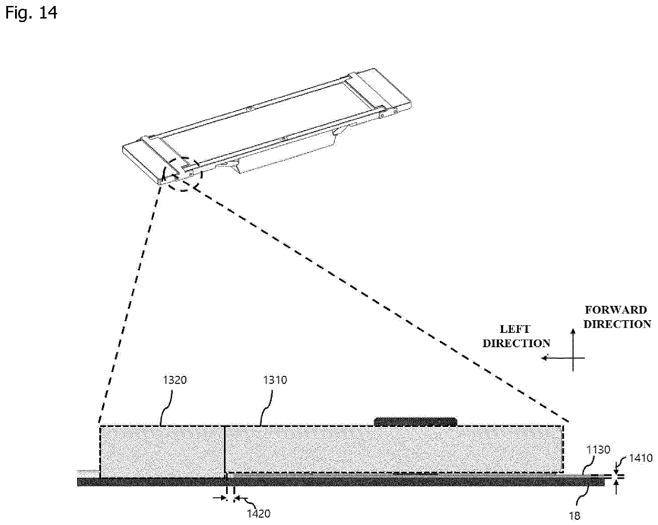

FIG. 13 is a view for describing a fixing bracket according to one embodiment of the present invention. Further, FIG. 14 is a view for describing a fixing bracket according to one embodiment of the present invention.

FIG. 13 illustrates a perspective view of a radiation detector 10. FIG. 14 illustrates a cross-sectional view of the radiation detector 10. More specifically, FIG. 14 illustrates a cross-sectional view of a fixing bracket 1210.

Referring to FIGS. 13 and 14, the fixing bracket 1210 may include a protective cover 1310. The protective cover 1310 may cover at least a portion of one side of the front protection unit 1130. For example, the protective cover 1310 may cover at least a portion of the left side of the front protection unit 1130. Further, the protective cover 1310 may cover at least a portion of the right side of the front protection unit 1130. Referring to FIG. 14, the front protection unit 1130 may be positioned between the protective cover 1310 and the support member 18. FIG. 13 illustrates the fixing bracket 1210 divided with a dotted line, but this is only for description purposes, and the actual fixing bracket 1210 does not have a dotted line drawn.

Referring to FIGS. 13 and 14, the fixing bracket 1210 may include a fixing bracket frame 1320. The fixing bracket frame 1320 may be coupled to the protective cover 1310 in a first direction. The first direction may be, for example, a left direction. However, the present invention is not limited thereto, and the first direction may be a right direction. The fixing bracket frame 1320 may be positioned on the left side of the protective cover 1310 of the left fixing bracket 1210. The fixing bracket frame 1320 may be positioned on the right side of the protective cover 1310 of the right fixing bracket 1210. The fixing bracket frame 1320 may be in surface contact with the support member 18 so that the fixing bracket 1210 does not shake with respect to the support member 18.

Referring to FIG. 13, the fixing bracket 1210 may include a fixing bracket fixing part 1330. The fixing bracket fixing part 1330 may be coupled to the fixing bracket frame 1320 in a second direction, the fixing bracket fixing part 1330 may be coupled to the fixing bracket frame 1320 in a direction opposite to the second direction, and the second direction may be an upward direction. However, the present invention is not limited thereto, and the second direction may be a downward direction. The fixing bracket fixing part 1330 may have a plane perpendicular to the fixing bracket frame 1320. That is, when the fixing bracket frame 1320 is parallel to a front surface of the support member 18, the fixing bracket fixing part 1330 may be parallel to a lower or upper surface of the support member 18. The fixing bracket fixing part 1330 may be coupled to at least one of the lower and upper surfaces of the support member 18. The fixing bracket fixing part 1330 may be screw-coupled to the support member 18.

Referring to FIG. 14, one side surface of the protective cover 1310 may be formed concavely in the third direction with respect to one side surface of the fixing bracket frame 1320. The third direction may be a forward direction. The reason why one side surface of the protective cover 1310 is concavely formed in one side surface of the fixing bracket frame 1320 in the third direction may be that the protective cover 1310 forms a space for accommodating the front protection unit 1130. A height 1410 between one side surface of the protective cover 1310 and one side surface of the fixing bracket frame 1320 may be greater than or equal to a thickness of the front protection unit 1130. In this way, by covering at least a portion of the front protection unit 1130 with the protective cover 1310, the protective cover 1310 may aid the front protection unit 1130 to bend or return to its original state without any problem. Further, the protective cover 1310 may aid a constant distance to be maintained between the front protection unit 1130 and the detector panel 11. That is, the protective cover 1310 may prevent the left and right sides of the front protection unit 1130 from moving away from the detector panel 11.

Further, when the support member 18 is unfolded as shown in FIG. 13 and FIG. 14, a space 1420 may be formed between an end of one side of the front protection unit 1130 and the fixing bracket frame 1320 in the first direction. Here, the first direction may be a left direction. Further, unlike FIGS. 13 and 14, as the support member 18 is bent, the space 1420 between the end of one side of the front protection unit 1130 and the fixing bracket frame 1320 in the first direction may be gradually reduced. However, the present invention is not limited thereto, and unlike FIGS. 13 and 14, as the support member 18 is bent, the space 1420 between the end of one side of the front protection unit 1130 and the fixing bracket frame 1320 in the first direction may be gradually increased. When the support member 18 is unfolded in this way, the space 1420 is formed between the end of one side of the front protection unit 1130 and the fixing bracket frame 1320 in the first direction, and thus the protective cover 1310 may cover the front protection unit 1130 without any problem even when the support member 18 is bent.

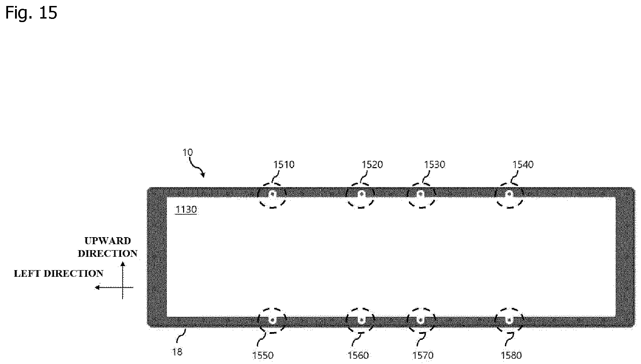

FIG. 15 is a view for describing a front protection unit according to one embodiment of the present invention.

In FIGS. 11 to 14, examples in which the fixing part included in the front protection unit 1130 is positioned at the center of the front protection unit 1130 in a leftright direction have been described. However, the present invention is not limited thereto. As illustrated in FIG. 15, a fixing part of a front protection unit 1130 may be positioned at a position other than the center of the front protection unit 1130 in the leftright direction. For example, the front protection unit 1130 may include upper fixing parts 1510, 1520, 1530, and 1540. Further, the front protection unit 1130 may include lower fixing parts 1550, 1560, 1570, and 1580.

In FIG. 15, four upper fixing parts 1510, 1520, 1530, and 1540 are illustrated as being included in the upper side of the front protection unit 1130 and four lower fixing parts 1550, 1560, 1570, and 1580 as being included in the lower side of the front protection unit 1130. However, the present invention is not limited thereto. The number of upper fixing parts may be two or more. Further, the number of lower fixing parts may be two or more. Further, the upper fixing parts 1510, 1520, 1530, and 1540 and the lower fixing parts 1550, 1560, 1570, and 1580 may include long holes extending leftward and rightward different from circular holes. However, the present invention is not limited thereto. In this way, when the front protection unit 1130 includes a plurality of upper fixing parts and a plurality of lower fixing parts, the front protection unit 1130 may be firmly fixed to a support member 18. Therefore, the front protection unit 1130 can be prevented from shaking with respect to the support member 18. Further, a constant distance between the front protection unit 1130 and a detector panel 11 may be maintained. Therefore, an image of the radiation detector 10 may not be distorted by the front protection unit 1130.

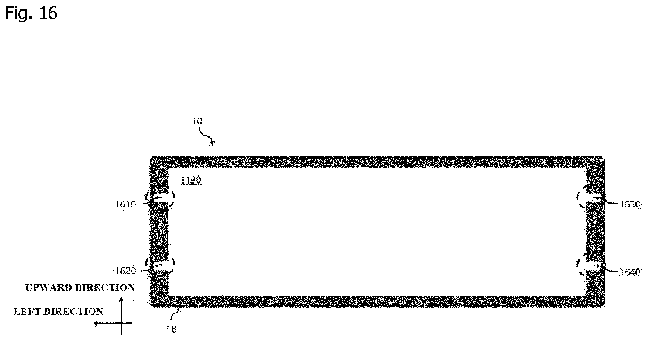

FIG. 16 is a view for describing a front protection unit according to one embodiment of the present invention.

A front protection unit 1130 may include left fixing parts 1610 and 1620 and right fixing parts 1630 and 1640. At least one of the left fixing parts 1610 and 1620 may be formed to protrude leftward from the front protection unit 1130. Further, at least one of the right fixing parts 1630 and 1640 may be formed to protrude to the right side of the front protection unit 1130. The right fixing parts 1630 and 1640 and the left fixing parts 1610 and 1620 may be screw-coupled to a support member 18. The left fixing parts 1610 and 1620 and the right fixing parts 1630 and 1640 may have long holes extending leftward and rightward.

In this way, when the front protection unit 1130 includes the left fixing parts 1610 and 1620 and the right fixing parts 1630 and 1640, the front protection unit 1130 may be firmly fixed to the support member 18. Therefore, the front protection unit 1130 can be prevented from shaking with respect to the support member 18. Further, a constant distance between the front protection unit 1130 and the detector panel 11 may be maintained. Therefore, an image of the radiation detector 10 can be prevented from being distorted by the front protection unit 1130. Further, the right fixing parts 1630 and 1640 and the left fixing parts 1610 and 1620 may prevent deformation of the front protection unit 1130.

In FIG. 15, the front protection unit 1130 includes upper fixing parts 1510, 1520, 1530, and 1540 and lower fixing parts 1550, 1560, 1570, and 1580. Further, in FIG. 16, the front protection unit 1130 includes left fixing parts 1610 and 1620 and right fixing parts 1630 and 1640. By combining those of FIGS. 15 and 16, the front protection unit 1130 may include upper fixing parts 1510, 1520, 1530, and 1540, lower fixing parts 1550, 1560, 1570, and 1580, left fixing parts 1610 and 1620, and right fixing parts 1630 and 1640. In this way, when the front protection unit 1130 includes the upper fixing parts 1510, 1520, 1530, and 1540, the lower fixing parts 1550, 1560, 1570, and 1580, the left fixing parts 1610 and 1620, and the right fixing parts 1630 and 1640, the front protection unit 1130 may be firmly fixed to the support member 18. Therefore, the front protection unit 1130 can be prevented from shaking with respect to the support member 18.

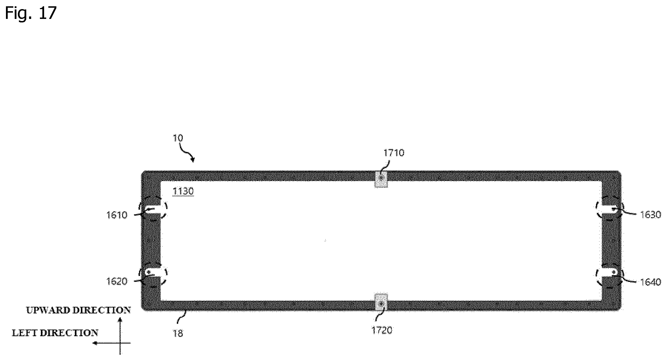

FIG. 17 is a view for describing a front protection unit according to one embodiment of the present invention.

Referring to FIG. 17, similarly to FIG. 16, a front protection unit 1130 may include left fixing parts 1610 and 1620 and right fixing parts 1630 and 1640. In addition, the front protection unit 1130 may include an upper bracket 1710 and a lower bracket 1720. The upper bracket 1710 and the lower bracket 1720 may prevent the front protection unit 1130 from being lifted from a detector panel 11 and a support member 18.

The upper bracket 1710 and the lower bracket 1720 may extend upward and downward. One side of the upper bracket 1710 may be screw-coupled to the support member 18, and the other side may be brought into contact with the front protection unit 1130. Therefore, an upper side of the front protection unit 1130 may be fixed by the upper bracket 1710. The other side of the lower bracket 1720 may be screw-coupled to the support member 18, and one side may be brought into contact with the front protection unit 1130. Therefore, a lower side of the front protection unit 1130 may be fixed by the lower bracket 1720. Unlike FIG. 11, upper and lower sides of the front protection unit 1130 are not fixed to the support member 18 but are fixed by frictional force by the upper bracket 1710 and the lower bracket 1720, and thus the front protection unit 1130 may move slightly with respect to the support member 18 so that the front protection unit 1130 can be prevented from being deformed by bending. Further, since the upper bracket 1710 and the lower bracket 1720 may rotate around an axis extending forward and backward to detach the front protection unit 1130 from the support member 18, the assembly of the front protection unit 1130 can be improved. Further, since the upper bracket 1710 and the lower bracket 1720 may move the front protection unit 1130 to the left or right direction while the upper bracket 1710 and the lower bracket 1720 remain stationary, to detach the front protection unit 1130 from the support member 18, the assembly of the front protection unit 1130 can be improved.

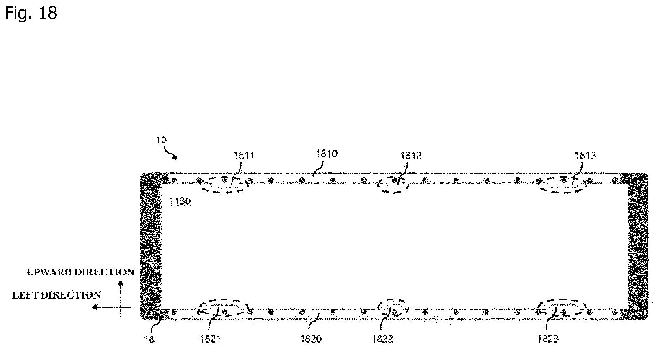

FIG. 18 is a view for describing a front protection unit according to one embodiment of the present invention.

A radiation detector 10 may include fixing brackets 1810 and 1820. At least a portion of the fixing brackets 1810 and 1820 may be positioned at one or more of a support member 18 and a front protection unit 1130 in a third direction. The third direction may be a forward direction. However, the present invention is not limited thereto, and the third direction may be a rearward direction. The fixing brackets may extend in a first direction. The first direction may be a left direction. However, the present invention is not limited thereto, and the first direction may be a right direction. The fixing brackets 1810 and 1820 may include an upper fixing bracket 1810 and a lower fixing bracket 1820.

The fixing brackets 1810 and 1820 may cover at least a portion of one side of the front protection unit 1130. For example, the upper fixing bracket 1810 may cover at least a portion of the upper side of the front protection unit 1130. Further, the lower fixing bracket 1820 may cover at least a portion of the lower side of the front protection unit 1130. The fixing brackets 1810 and 1820 may be fixed to the support member 18. For example, the fixing brackets 1810 and 1820 may be screw-coupled to the support member 18.

The upper fixing bracket 1810 may include upper separation prevention parts 1811, 1812, and 1813 that protrude downward to prevent detachment of the front protection unit 1130. In FIG. 18, although three upper separation prevention parts 1811, 1812, and 1813 are illustrated, the present invention is not limited thereto, and two or more upper separation prevention parts may be provided. The lateral lengths of the upper separation prevention parts 1811, 1812, and 1813 may be reduced toward the center of the front protection unit 1130 and may be increased in a left or right direction of the front protection unit 1130. For example, the lateral lengths of the upper separation prevention part 1812 positioned at the center may be smaller than the lateral lengths of the upper separation prevention part 1811 positioned at the left and the upper separation prevention part 1813 positioned at the right. In this way, the lateral lengths of the upper separation prevention parts 1811, 1812, and 1813 may be reduced toward the center of the front protection unit 1130, and thus the deformation of the front protection unit 1130 may be reduced. Further, by increasing the flexibility of the front protection unit 1130, a surface of the radiation detector 10 may closely approach a surface of a round subject.

The lower fixing bracket 1820 may include lower separation prevention parts 1821, 1822, and 1823 that protrude upward to prevent detachment of the front protection unit 1130. In FIG. 18, although three lower separation prevention parts 1821, 1822, and 1823 are illustrated, the present invention is not limited thereto, and two or more lower separation prevention parts may be provided. The lateral lengths of the lower separation prevention parts 1821, 1822, and 1823 may be reduced toward the center of the front protection unit 1130 and may be increased in the left or right direction of the front protection unit 1130. For example, the lateral lengths of the lower separation prevention part 1822 positioned at the center may be smaller than the lateral lengths of the lower separation prevention part 1821 positioned at the left and the lower separation prevention part 1823 positioned at the right. In this way, the lateral lengths of the lower separation prevention parts 1821, 1822, and 1823 may be reduced toward the center of the front protection unit 1130, and thus the deformation of the front protection unit 1130 may be reduced. Further, by increasing the flexibility of the front protection unit 1130, a surface of the radiation detector 10 may closely approach a surface of a round subject.

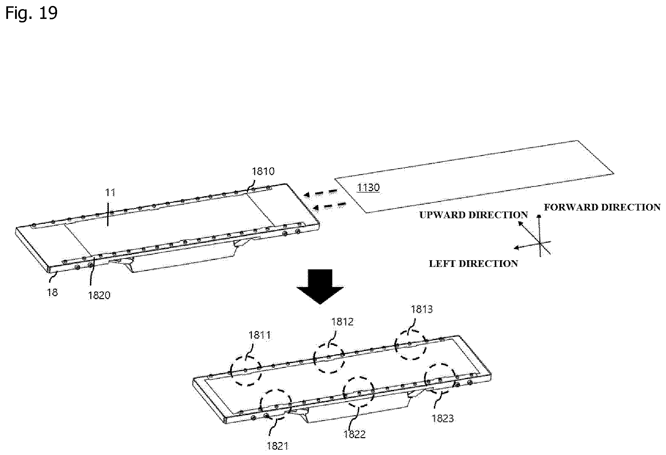

FIG. 19 is a view for describing a connection of a support member 18 and a front protection unit according to one embodiment of the present invention.

Referring to FIG. 19, an upper fixing bracket 1810 and a lower fixing bracket 1820 may be coupled to a support member 18. A front protection unit 1130 may be coupled to the support member 18 by being slid along the upper fixing bracket 1810 and the lower fixing bracket 1820. The front protection unit 1130 may be guided by the upper fixing bracket 1810 and the lower fixing bracket 1820. Further, the front protection unit 1130 can be prevented from being detached from the support member 18 by the upper separation prevention parts 1811, 1812, and 1813 and the lower separation prevention parts 1821, 1822, and 1823.

The upper separation prevention parts 1811, 1812, and 1813 and the lower separation prevention parts 1821, 1822, and 1823 may be brought into contact with the front protection unit 1130 to fix the front protection unit 1130 to the support member 18. Rear surfaces of the upper separation prevention parts 1811, 1812, and 1813 and the lower separation prevention parts 1821, 1822, and 1823 that are brought into contact with the front protection unit 1130 may include an elastic material. For example, the elastic material may include at least one of rubber, urethane, and silicone. The upper separation prevention parts 1811, 1812, and 1813 and the lower separation prevention parts 1821, 1822, and 1823 may be in contact with the front protection unit 1130 and prevent the front protection unit 1130 from being detached from the support member 18 by frictional force. However, the present invention is not limited thereto, and the upper separation prevention parts 1811, 1812, and 1813 and the lower separation prevention parts 1821, 1822, and 1823 may not be brought into contact with the front protection unit 1130.

In a radiation detector 10 in FIG. 19, user convenience can be increased because the user may fix the front protection unit 1130 to the support member 18 simply by sliding the front protection unit 1130 along the upper fixing bracket 1810 and the lower fixing bracket 1820 of the support member 18.

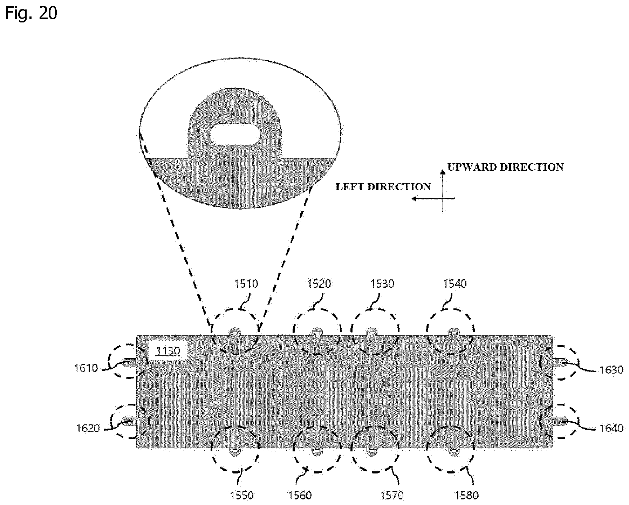

FIG. 20 is a view for describing an additional example of the front protection unit according to one embodiment of the present invention.

FIG. 20 illustrates a front protection unit 1130 that is formed by a combination of those in FIGS. 15 and 16. Referring to FIGS. 15, 16, and 20, the front protection unit 1130 may include upper fixing parts 1510, 1520, 1530, and 1540. Further, the front protection unit 1130 may include lower fixing parts 1550, 1560, 1570, and 1580. Further, the front protection unit 1130 may include left fixing parts 1610 and 1620 and right fixing parts 1630 and 1640.

The upper fixing parts 1510, 1520, 1530, and 1540, the lower fixing parts 1550, 1560, 1570, and 1580, the right fixing parts 1630 and 1640, and the left fixing parts 1610 and 1620 may be screw-coupled to a support member 18. The upper fixing parts 1510, 1520, 1530, and 1540, the lower fixing parts 1550, 1560, 1570, and 1580, the left fixing parts 1610 and 1620, and the right fixing parts 1630 and 1640 may have long holes extending leftward and rightward. Therefore, the front protection unit 1130 may be coupled to the support member 18 to be moved left and right. Since the front protection unit 1130 may be moved left and right with respect to the support member 18, the front protection unit 1130 may not be deformed even when the process of the front protection unit 1130 bending or unfolding is repeated. Further, the front protection unit 1130 may be firmly coupled to the support member 18 by the upper fixing parts 1510, 1520, 1530, and 1540, the lower fixing parts 1550, 1560, 1570, and 1580, the left fixing parts 1610 and 1620, and the right fixing parts 1630 and 1640.

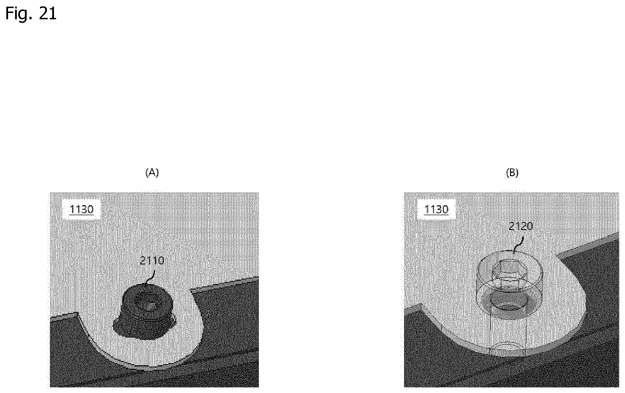

FIG. 21 illustrates views for describing a screw connection according to one embodiment of the present invention.

As described above, the front protection unit 1130 may be screw-coupled to the support member 18. That is, the screw may pass through the hole of the front protection unit 1130 and be coupled to the support member 18.

Referring to FIG. 21A, at least one of the upper fixing parts 1510, 1520, 1530, and 1540, the lower fixing parts 1550, 1560, 1570, and 1580, the left fixing parts 1610 and 1620, and the right fixing parts 1630 and 1640 may have a long hole extending leftward and rightward. Therefore, even when a screw 2110 is coupled, the front protection unit 1130 may be moved left and right with respect to the support member 18. Since the front protection unit 1130 may be moved left and right with respect to the support member 18, the front protection unit 1130 may not cause a burden on the detector panel 11 and the support member 18 when the support member 18 is bent. The durability of the radiation detector 10 can be increased.

Referring to FIG. 21B, at least one of the upper fixing parts 1510, 1520, 1530, and 1540, the lower fixing parts 1550, 1560, 1570, and 1580, the left fixing parts 1610 and 1620, and the right fixing parts 1630 and 1640 may have a circular hole. A diameter of the circular hole may be greater than a diameter of a screw 2120. Here, the screw 2120 may be a portion where a screw thread is formed. The diameter of the circular hole may be 1.5 times or more and 2 times or less the diameter of the screw 2120. Therefore, the front protection unit 1130 may be moved left, right, up, and down with respect to the support member 18. Since the front protection unit 1130 may be moved left and right with respect to the support member 18, the front protection unit 1130 may not cause a burden on the detector panel 11 and the support member 18 when the support member 18 is bent. As illustrated in FIG. 21B, a diameter of a head of the screw may be greater than a diameter of at least one of the circular holes of the upper fixing parts 1510, 1520, 1530, and 1540, the lower fixing parts 1550, 1560, 1570, and 1580, the left fixing parts 1610 and 1620, and the right fixing parts 1630 and 1640.

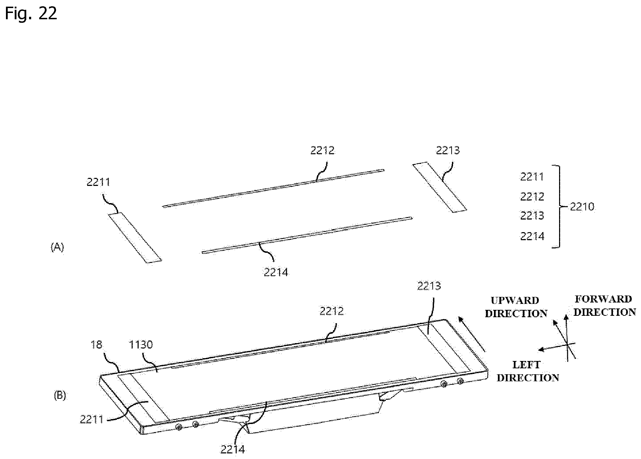

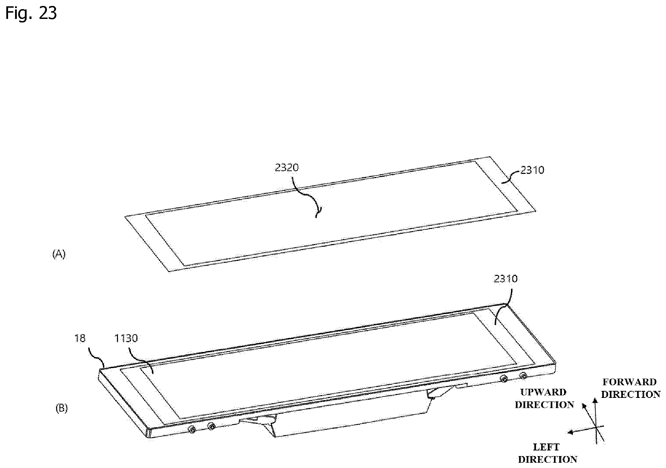

FIG. 22 illustrates views for describing a front protection unit according to one embodiment of the present invention. FIG. 23 illustrates views for describing a front protection unit according to one embodiment of the present invention.

The front protection unit 1130 may include a magnetic coupling unit. The magnetic coupling unit may be positioned on a front or rear surface of a front protection unit 1130. The magnetic coupling unit may be positioned on at least a portion of four sides of the front protection unit 1130. The magnetic coupling unit may include a magnet or a metal material having magnetism.

The magnetic coupling unit of the front protection unit 1130 may be coupled to a magnet or a metal material having magnetism of a support member 18. Therefore, the front protection unit 1130 may be coupled to the support member 18. In this way, when the magnetic coupling unit is used, the front protection unit 1130 and the support member 18 may be coupled simply by placing the front protection unit 1130 on the support member 18, and thus the front protection unit 1130 and the support member 18 may be very easily assembled. Further, when the positions of the front protection unit 1130 and the support member 18 are substantially aligned, the front protection unit 1130 may be coupled to the support member 18 in a certain direction and position by magnetic force, and thus the user convenience can be improved. Further, the polarity of the magnet may be used to couple the front protection unit 1130 to the support member 18 only when the front protection unit 1130 is positioned in a specific direction.

FIG. 22A illustrates a magnetic coupling unit 2210. The magnetic coupling unit 2210 may include at least one of a left magnetic coupling unit 2211, an upper magnetic coupling unit 2212, a right magnetic coupling unit 2213, and a lower magnetic coupling unit 2214. The magnetic coupling unit 2210 may be adhered to a rear surface of the front protection unit 1130. The front protection unit 1130 may be coupled to the support member 18 by magnetic force of the magnetic coupling unit 2210 and the support member 18.

However, the present invention is not limited thereto, and the magnetic coupling unit 2210 may not be adhered to the front protection unit 1130. Referring to FIG. 22B, the user may place the front protection unit 1130 on the support member 18. The front protection unit 1130 may be in a state of being movable in front of the support member 18. In this case, the magnetic coupling unit 2210 may be positioned on a front surface of the front protection unit 1130. The magnetic coupling unit 2210 may be coupled to the support member 18 by magnetic force. The front protection unit 1130 disposed between the magnetic coupling unit 2210 and the support member 18 may be fixed to the support member 18 by friction.

FIG. 23A illustrates a magnetic coupling unit 2310. The magnetic coupling unit 2310 may be adhered to a rear surface of the front protection unit 1130. A front protection unit 1130 may be coupled to the support member 18 by the magnetic force of the magnetic coupling unit 2310 and the support member 18.

However, the present invention is not limited thereto, and the magnetic coupling unit 2310 may not be adhered to the front protection unit 1130. The magnetic coupling unit 2310 may have a magnet or a metal material having magnetism. The magnetic coupling unit 2310 may be formed along four sides of the front protection unit. The magnetic coupling unit 2310 may have a shape with a hole 2320 formed at a center thereof. Referring to FIG. 23B, the magnetic coupling unit 2310 may be positioned at the front protection unit 1130 in a third direction. The third direction may be a forward direction. The magnetic coupling unit 2310 may be coupled to a magnet or a metal material having magnetism of the support member 18 to couple the front protection unit 1130 to the support member 18. The front protection unit 1130 disposed between the magnetic coupling unit 2310 and the support member 18 may be fixed to the support member 18 by friction.

The radiation detector 10 may include a control unit and a sensor unit. The sensor unit may be a sensor that detects a magnetic field. The sensor unit may be positioned on the support member 18. The control unit may detect whether the magnetic coupling units 2210 and 2310 are coupled to the support member 18 on the basis of a signal of the sensor unit. That is, the control unit may determine that the magnetic coupling units 2210 and 2310 are coupled to the support member 18 when the sensor unit detects a magnetic flux greater than or equal to a threshold magnetic flux. Further, the control unit may determine that the magnetic coupling units 2210 and 2310 are coupled to the support member 18 when the sensor unit detects a magnetic force greater than or equal to a threshold magnetic force. Further, the control unit may determine that the magnetic coupling units 2210 and 2310 are not coupled to the support member 18 when the sensor unit detects the magnetic flux less than the threshold magnetic flux. Further, the control unit may determine that the magnetic coupling units 2210 and 2310 are not coupled to the support member 18 when the sensor unit detects the magnetic force less than the threshold magnetic force. The fact that the magnetic coupling units 2210 and 2310 are coupled to the support member 18 may mean that the front protection unit 1130 is coupled to the support member 18. The support member 18 may include a plurality of sensor units. The control unit may determine that the magnetic coupling units 2210 and 2310 are coupled to the support member 18 only when all of magnetic fluxes measured by the plurality of sensor units are greater than or equal to a threshold magnetic flux.

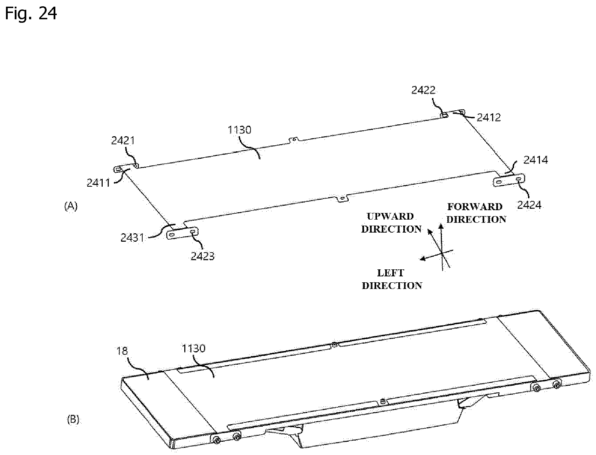

FIG. 24 illustrates views for describing a front protection unit according to one embodiment of the present invention.

Referring to FIG. 24A, a front protection unit 1130 may include front protection unit connection units 2411, 2412, 2413, and 2414 positioned at least one of the upper left side, upper right side, lower left side, and lower right side. The front protection unit connection units 2411 and 2412 positioned at the upper left side and upper right side may extend upward from the front protection unit 1130. Further, the front protection unit connection units 2413 and 2414 positioned at the lower left side and lower right side may extend downward from the front protection unit 1130.

Referring to FIG. 24A, the front protection unit 1130 may include front protection unit fixing units 2421, 2422, 2423, and 2424. The front protection unit fixing units 2421, 2422, 2423, and 2424 may be coupled to the front protection unit connection units 2411, 2412, 2413, and 2414. The front protection unit fixing units 2421, 2422, 2423, and 2424 may be components for connecting the front protection unit 1130 to the support member 18. Further, the front protection unit fixing units 2421, 2422, 2423, and 2424 may have a surface that is perpendicular to the front protection unit. The upper left front protection unit fixing unit 2421 may be screw-coupled to the left side of an upper surface of the support member 18. The upper right front protection unit fixing unit 2422 may be screw-coupled to the right side of the upper surface of the support member 18. The lower left front protection unit fixing unit 2423 may be screw-coupled to the left side of a lower surface of the support member 18. The lower right front protection unit fixing unit 2SS424 may be screw-coupled to the right side of the lower surface of the support member 18. The front protection unit fixing units 2421, 2422, 2423, and 2424 may have at least one long hole formed extending leftward and rightward. Since the front protection unit 1130 may be moved left and right with respect to the support member 18 by the long hole, the front protection unit 1130 may not cause a burden on the detector panel 11 and the support member 18 when the support member 18 is bent. The durability of the radiation detector 10 can be increased.

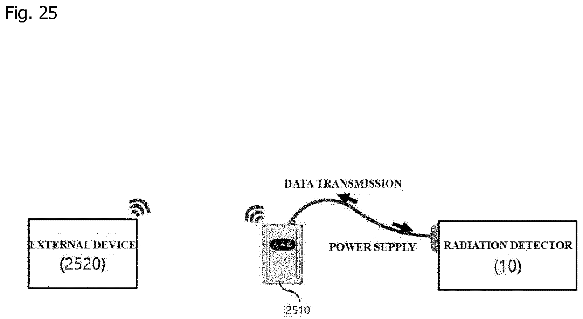

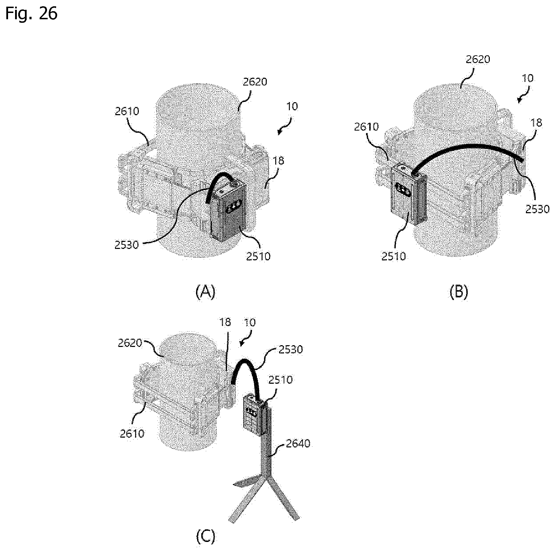

When radiation detectors are used outdoors, wireless communication may be required. In this case, detectors that do not include a communication module only communicate through wired communication, and thus there is a disadvantage in that cables are required to couple to an external device. Further, depending on the usage environment, increasing the length of the cable may result in a decrease in reliability of data transmission through the cable. Therefore, there is a case in which a wireless module for supporting wireless communication is coupled to a wired radiation detector. Hereinafter, a wireless module according to one embodiment of the present invention will be described with reference to FIGS. 25 and 26.

FIG. 25 is a block diagram illustrating a communication unit according to one embodiment of the present invention.

A radiation detector 10 may further include a wireless module 2510. The wireless module 2510 may be electrically coupled to a support member 18. For example, the wireless module 2510 may be coupled to the support member 18 with a cable. The cable may include at least one of a power cable and a communication cable. The power cable and the communication cable may be implemented as different lines, but the present invention is not limited thereto, and the same line may serve as the power cable and the communication cable. For example, the communication cable may serve as the power cable. Since the power cable is generally thick, the communication cable may be responsible for both power supply and communication, and thus the volume of the cable may be significantly reduced.

The wireless module 2510 may supply power to the radiation detector 10. More specifically, the wireless module 2510 may supply power to the radiation detector 10 through the power cable. More specifically, the wireless module 2510 includes a battery or a power supply, and may supply electric energy to the radiation detector 10 through the power cable. However, the present invention is not limited thereto, and the radiation detector 10 may supply electric energy to the wireless module 2510 through the power cable.

The wireless module 2510 may supply electric energy that the radiation detector 10 uses for communication. Therefore, a process of connecting an additional power supply to the radiation detector 10 for communication may be eliminated.

Further, the wireless module 2510 may support wireless communication with an external device 2520. More specifically, the radiation detector 10 may communicate with the wireless module 2510 in a wired manner through the communication cable. The radiation detector 10 may transmit data to the external device 2520 through the wireless module 2510. For example, the radiation detector 10 transmits data to the wireless module 2510, and the wireless module 2510 may communicate with the external device 2520 in a wireless manner. The data transmitted by the radiation detector 10 to the wireless module 2510 may be data related to an image. The external device 2520 may receive data and display an image. The external device 2520 may include at least one of an external controller and an external computer. The external computer may be implemented as at least one of a personal computer (PC), a tablet computer, and a smartphone. Further, the radiation detector 10 may receive data from the external device 2520 through the wireless module 2510. For example, the wireless module 2510 may receive data from the external device 2520. The wireless module 2510 may transmit the data received from the external device 2520 to the radiation detector 10 through the communication cable. The data received from the external device 2520 may be a command signal for controlling the radiation detector 10.

FIG. 26 illustrates views illustrating examples related to the installation form of a wireless module according to one embodiment of the present invention.

Referring to FIG. 26, a radiation detector 10 may include a fixing band 2610. The fixing band 2610 may couple one side and the other side of a support member 18. A target object 2620 may be surrounded by the fixing band 2610 and the radiation detector 10. Therefore, the radiation detector 10 may be movably fixed to the target object 2620 and capture an image of the target object 2620. The fixing band 2610 may include an elastic material. Further, connection units for connection to the support member 18 may be formed on one side and the other side of the fixing band 2610.

Referring to FIG. 26A, the wireless module 2510 may be coupled to the support member 18. More specifically, the wireless module 2510 may be coupled to a rear surface of the support member 18. Further, the wireless module 2510 may be coupled to the support member 18 and a power/communication cable 2630. For example, a communication terminal of the wireless module 2510 and a communication terminal of the support member 18 may be coupled to the power/communication cable 2530. One side of the power/communication cable 2630 is coupled to the communication terminal of the wireless module 2510, and the other side of the power/communication cable 2630 may be coupled to the communication terminal of the support member 18. However, the present invention is not limited thereto, and the communication terminal is formed at a connection portion of the wireless module 2510 and the support member 18, and thus a separate cable may not be used between the wireless module 2510 and the support member 18. According to the connection of the wireless module 2510 and the radiation detector 10 according to FIG. 26A, a length of the power/communication cable 2630 is small, and thus stable communication and power supply is possible. Further, contact of an external material with the power/communication cable 2630 can be minimized. Further, when the radiation detector 10 and the wireless module 2510 are coupled, there is an advantage of easy portability because no separate installation tool is required. In this case, as a method of connecting the radiation detector 10 and the wireless module 2510, Velcro attachment, shape connection, bolting connection, or the like may be used.

Referring to FIG. 26B, the wireless module 2510 may be coupled to the fixing band 2610. Further, the wireless module 2510 may be coupled to the support member 18 by the power/communication cable 2630. For example, the communication terminal of the wireless module 2510 and the communication terminal of the support member 18 may be coupled by the power/communication cable 2530. According to the connection of the wireless module 2510 and the radiation detector 10 according to FIG. 26B, the position of the wireless module 2510 may be freely changed within the fixing band 2610, and thus the position of the wireless module 2510 may be adjusted according to an environment. Further, when stored, the wireless module 2510 may be stored together with the fixing band 2610 and stored so that the fixing band 2610 surrounds the wireless module 2510, and thus there is an advantage in that the inconvenience of carrying the fixing band 2610 and the wireless module 2510 separately is reduced and storage becomes more convenient.

Referring to FIG. 26C, the wireless module 2510 may be coupled to a mount 2640 independent of the radiation detector 10. Further, the communication terminal of the wireless module 2510 and the communication terminal of the support member 180 may be coupled to the power/communication cable 2630. According to the combination of the wireless module 2510 and the radiation detector 10 according to FIG. 26C, the position of the wireless module 2510 is free, and thus the wireless module 2510 may be positioned in a place where smooth communication with an external device can be achieved. Further, since the position of the wireless module 2510 may be freely determined according to the situation at the site, convenience can be increased. Further, since the wireless module 2510 may be disposed to avoid objects that cause communication interference at the site, communication interference between the external device 2520 and the radiation detector 10 can be minimized.

As described above, depending on the site where the radiation detector is used, the use of a wireless module can reduce radiation exposure to the user by allowing the user to be at a sufficient distance from the photographing position, and can also aid the user avoid other hazards present in the site. Further, communication interference due to hardware characteristics of the radiation detector can be minimized, and stable communication between the radiation detector and an external device can be achieved through an antenna built into the wireless module.

Further, power for wired communication may be supplied by a battery of the wireless module. Further, since a lighter communication cable than the power cable may be used, problems that may occur during the construction of the inspection environment (such as topographical constraints, communication interference, and cable disconnection) can be minimized. Further, some functions installed in the radiation detector may be installed in the wireless module to differentiate the functions, and thus the radiation detector may be made lighter. An antenna of the wireless module may be implemented with any of various antennas such as a built-in patch antenna, an external monopole antenna, etc. Therefore, the wireless module may provide a communication environment optimized for the usage environment to the radiation detector.

While embodiments have been described above in detail, the scope of embodiments of the present invention is not limited thereto but encompasses several modifications and improvements by those skilled in the art using basic concepts of embodiments of the present invention defined by the appended claims.

## Claims

1. A radiation detector comprising:
a detector panel;
a front protection panel and a rear protection panel that are disposed at both sides of the detector panel; and
a support member supporting the detector panel and the front and rear protection panels,
wherein the detector panel and the front and rear protection panels are bendable together in two directions.

2. The radiation detector of claim 1, wherein the detector panel and the front and rear protection panels are bendable together in a state in which a difference in displacement with respect to each other is allowed.

3. The radiation detector of claim 2, wherein each of the front and rear protection panels includes a fastening slot,
the support member includes a fastening rod that is inserted into the fastening slot and support the front and rear protection panels, and
the fastening slot has a long hole shape to allow relative movement along the fastening slot when the front and rear protection panels are bent together.

4. The radiation detector of claim 3, wherein each of the front and rear protection panels includes a movement-limiting fastening slot,
the support member includes a movement-limiting fastening rod inserted into the movement-limiting fastening slot, and
the movement-limiting fastening slot is configured to block movement of the movement-limiting fastening rod within the movement-limiting fastening slot when the front and rear protection panels are bent.

5. The radiation detector of claim 3, further comprising a front cover disposed in front of the front protection panel,
wherein the fastening rod passes through the fastening slots of the front and rear protection panels and is fastened to the front cover.

6. The radiation detector of any one claim of claims 1 to 5, wherein the support member includes a first support and a second support that are disposed to be spaced apart from each other, a bending part that couples the first and second supports and is formed to be bendable, a fixed support block that is fixedly provided on the first support, and a movable support block that is movably provided on the second support, and
an end portion of one side of the detector panel is fixed to the fixed support block and an end portion of the other side is fixed to the movable support block.

7. The radiation detector of claim 1, wherein the detector panel includes:
a thin film transistor (TFT) array including a plurality of pixel TFT circuits, each of which generates an output signal according to intensity of detected X-rays;
a gate circuit configured to apply a gate signal for driving the plurality of pixel TFT circuits to the TFT array; and
a readout circuit configured to receive the output signals generated by the plurality of pixel TFT circuits and transmit the received output signals to an external device,
the gate circuit includes:
a gate chip-on-film configured to generate the gate signal and apply the generated gate signal to the TFT array; and
a gate connection flexible printed circuit board (FPCB) that is circuit-coupled to the gate chip-on-film to receive a driving signal for generating the gate signal and transmit the received driving signal to the gate chip-on-film, and
the gate chip-on-film and the gate connection FPCB are disposed along different sides of the detector panel.

8. The radiation detector of claim 7, wherein the gate connection FPCB is disposed along a side of the detector panel that is the same as a side on which the readout circuit is disposed.

9. The radiation detector of claim 8, wherein the gate chip-on-film is disposed along one side of the detector panel, and
the gate connection FPCB and the readout circuit are disposed together along a side adjacent to the one side of the detector panel on which the gate chip-on-film is disposed.

10. The radiation detector of claim 9, wherein the readout circuit is formed of a readout chip-on-film.

11. The radiation detector of claim 1, further comprising a front protection unit that is positioned at the detector panel in a third direction to protect the detector panel, has a larger area than the exposed detector panel to cover the detector panel, has at least a portion fixed to the support member, is formed integrally, has flexibility, and is attachable to and detachable from the detector panel.

12. The radiation detector of claim 11, wherein a material of the front protection unit is a thin plate having radiation transmittance and resilience, and a thickness of the front protection unit is 0.1 T or more and 1 T or less.

13. The radiation detector of claim 11, wherein an upper fixing part is formed to protrude upward from an upper surface of the front protection unit,
a lower fixing part is formed to protrude downward from a lower surface of the front protection unit,
the upper fixing part and the lower fixing part are screw-coupled to the support member, and
holes formed in the upper and lower fixing parts are circular holes different from long holes extending leftward and rightward.

14. The radiation detector of claim 11, wherein at least one left fixing part is formed to protrude leftward from a left side of the front protection unit,
at least one right fixing part is formed to protrude rightward from a right side of the front protection unit,
the right fixing part and the left fixing part are screw-coupled to the support member, and
the left fixing part and the right fixing part have long holes extending leftward and rightward.

15. The radiation detector of claim 11, wherein the radiation detector includes a fixing bracket that has at least a portion positioned at one or more of the support member and the front protection unit in the third direction, covers at least a portion of one side of the front protection unit, and is fixed to the support member,
the fixing bracket extends in the first direction and includes an upper fixing bracket and a lower fixing bracket,
the upper fixing bracket includes an upper separation prevention part that protrudes downward to prevent detachment of the front protection unit, and
the lower fixing bracket includes a lower separation prevention part that protrudes upward to prevent detachment of the front protection unit.

16. The radiation detector of claim 11, wherein at least some of four sides of the front protection unit include a magnetic coupling unit including a magnet or a metal material having magnetism, and
the magnetic coupling unit of the front protection unit is coupled to a magnet or a metal material having magnetism of the support member so that the front protection unit is coupled to the support member.

17. The radiation detector of claim 11, wherein the radiation detector includes a magnetic coupling unit that has a magnet or a metal material having magnetism, has a shape formed along four sides of the front protection unit with a hole at a center thereof, and is positioned at the front protection unit in the third direction and coupled to a magnet or a metal material having magnetism of the support member to couple the front protection unit to the support member.

18. The radiation detector of claim 1, further comprising a wireless module that is electrically coupled to the support member, supports wireless communication with an external device, and supplies power to the radiation detector,
wherein the radiation detector transmits data to the external device through the wireless module and receives data from the external device.

19. The radiation detector of claim 18, wherein the wireless module is coupled to the support member or coupled to a fixing band connection one side and the other side of the support member, and
a communication terminal of the wireless module and a communication terminal of the support member are coupled by a power/communication cable.

20. The radiation detector of claim 18, wherein the wireless module is coupled to a mount independent of the radiation detector, and
a communication terminal of the wireless module and a communication terminal of the support member are coupled by a power/communication cable.
